# EUROPEAN PATENT APPLICATION

(11) **EP 4 459 963 A1**
(43) Date of publication of application: **06.11.2024**
(21) Application number: 22913721.1
(22) Date of filing: 24.10.2022
(51) Int. Cl.: H04M 1/02, F16C 11/04, G06F 1/16, G09F 9/30, E05F 1/12

(54) **ROTATING SHAFT ASSEMBLY AND ELECTRONIC DEVICE**

(30) Priority: 31.12.2021 CN 202111683486
(71) Applicant: GUANGDONG OPPO MOBILE TELECOMMUNICATIONS CORP., LTD., Dongguan, Guangdong 523860 (CN)
(72) Inventor: XU, Yaxing, Dongguan, Guangdong 523860 (CN); SHI, Changchun, Dongguan, Guangdong 523860 (CN); CHEN, Qiuliang, Dongguan, Guangdong 523860 (CN)
(74) Representative: Novagraaf Technologies
(86) International application number: PCT/CN2022/127108
(87) International publication number: WO 2023/124458

(57) **Abstract**

A rotating shaft assembly and an electronic device having same. The rotating shaft assembly (1) comprises a base (10) and two first rotating members (20) having opposite rotating directions. The first rotating members each comprises a first connecting end (201) and a second connecting end (202) opposite to each other. The first connecting ends are rotatably connected to the base, and the second connecting ends are configured to be rotatably connected to a housing (3). The first rotating members are configured to bear a flexible screen together with the housing rotatable about first rotating axes (L1). The first rotating members are rotatable about second rotating axes (L2). The two first rotating axes are located between the two second rotating axes. The rotating shaft assembly has a closed state that the distance between the two first connecting ends is greater than the distance between the two second connecting ends. The rotating shaft assembly enables two parts of the flexible screen to be attached to each other when an electronic product is in the closed state. The rotating shaft assembly has a simple structure and can reduce or even eliminate creases produced by bending of the flexible screen.

## Description

### TECHNICAL FIELD

The present disclosure relates to the technical field of rotating shaft assemblies, and in particular to a rotating shaft assembly and an electronic device.

### BACKGROUND

A rotating shaft assembly, as an important part of a flexible electronic device, is configured to cooperate with a housing to limit a shape of a flexible screen after the flexible screen is bent and folded. Some electronic devices are able to eliminate a gap between two halves of the flexible screen when the electronic devices are folded, thereby improving a visual performance, effectively protecting the flexible screen, and gaining popularity among a variety of users. However, a structure of the rotating shaft assembly currently applied to such electronic devices is relatively complicated.

### SUMMARY OF THE DISCLOSURE

In a first aspect, a rotating shaft assembly for an electronic device may be provided by some embodiments of the present disclosure. The electronic device includes a flexible screen and two housings. The rotating shaft assembly includes a base and two first rotating members that rotate in opposite directions. Each of the two first rotating members includes a first connecting end and a second connecting end disposed opposite to the first connecting end. The first connecting end is rotatably connected to the base. The second connecting end is configured to be rotatably connected to a corresponding one of the two housings. Each of the two first rotating members is configured to cooperate with a corresponding one of the two housings that is rotatable about a first rotation axis to support the flexible screen.

Along a direction substantially parallel to an arrangement direction of second rotation axes of the two first rotating members, the first rotation axes of the two housings are located between the second rotation axes of the two first rotating members. The rotating shaft assembly has a folded state where a distance between the first connecting ends of the two first rotating members is greater than a distance between the second connecting ends of the two first rotating members.

In a second aspect, an electronic device may be provided by some embodiments of the present disclosure. The electronic device includes a flexible screen, two housings, and the rotating shaft assembly provided in the first aspect of the present disclosure. At least a part of one of the two housings and at least a part of the other one of the two housings are disposed on opposite sides of the rotating shaft assembly. The housing is rotatably connected to the first rotating member of the rotating shaft assembly. The flexible screen is disposed on the same side of the two first rotating members and the two housings.

### BRIEF DESCRIPTION OF THE DRAWINGS

To further illustrate technical solutions provided by some embodiments of the present disclosure, drawings needed for the description of the embodiments are introduced below.
FIG. 1 is a schematic perspective structural view of a rotating shaft assembly in an unfolded state according to an embodiment of the present disclosure.
FIG. 2 is an exploded schematic view of FIG. 1.
FIG. 3 is a side elevational view of FIG. 1.
FIG. 4 is a top plan view of a rotating shaft assembly when the rotating shaft assembly is configured in an electronic device and in an unfolded state according to an embodiment of the present disclosure.
FIG. 5 is a partial cross-sectional view of FIG. 4 along an A-A direction according to an embodiment of the present disclosure.
FIG. 6 is a schematic perspective structural view of a rotating shaft assembly in a folded state according to an embodiment of the present disclosure.
FIG. 7 is a side elevational view of FIG. 6.
FIG. 8 is a top plan view of a rotating shaft assembly when the rotating shaft assembly is configured in an electronic device and in a folded state according to an embodiment of the present disclosure.
FIG. 9 is a partial cross-sectional view of the rotating shaft assembly illustrated in FIG. 8 along a B-B direction according to an embodiment of the present disclosure.
FIG. 10 is a schematic perspective structural view of a rotating shaft assembly according to another embodiment of the present disclosure.
FIG. 11 is a side elevational view of FIG. 10.
FIG. 12 is a schematic perspective structural view of a rotating shaft assembly according to still another embodiment of the present disclosure.
FIG. 13 is a side elevational view of FIG. 12.
FIG. 14 is a schematic perspective structural view of a rotating shaft assembly according to still another embodiment of the present disclosure.
FIG. 15 is a schematic perspective structural view of a rotating shaft assembly according to still another embodiment of the present disclosure.
FIG. 16 is an exploded schematic view of FIG. 15.
FIG. 17 is a schematic view of a first mating portion and a second mating portion according to an embodiment of the present disclosure.
FIG. 18 is a schematic perspective structural view of a rotating shaft assembly according to still another embodiment of the present disclosure.
FIG. 19 is a schematic perspective structural view of a rotating shaft assembly according to still another embodiment of the present disclosure.
FIG. 20 is an exploded schematic view of a first rotating shaft, a first mating portion, and a friction member according to an embodiment of the present disclosure.
FIG. 21 is a schematic perspective structural view of a rotating shaft assembly according to still another embodiment of the present disclosure.
FIG. 22 is a partial exploded schematic view of FIG. 21.
FIG. 23 is a schematic perspective structural view of a rotating shaft assembly according to still another embodiment of the present disclosure.
FIG. 24 is a partial exploded schematic view of FIG. 23.
FIG. 25 is a schematic perspective structural view of an electronic device after removing a flexible screen according to an embodiment of the present disclosure.
FIG. 26 is an exploded schematic view of FIG. 25.
FIG. 27 is a partial cross-sectional view of FIG. 4 along an A-A direction according to another embodiment of the present disclosure.
FIG. 28 is a partial cross-sectional view of FIG. 8 along a B-B direction according to another embodiment of the present disclosure.
FIG. 29 is a partial cross-sectional view of FIG. 4 along a C-C direction according to an embodiment of the present disclosure.
FIG. 30 is an exploded schematic view of a second support and a rotating shaft assembly according to an embodiment of the present disclosure.
FIG. 31 is a partial cross-sectional view of FIG. 30 along a D-D direction.
FIG. 32 is a partial cross-sectional view of FIG. 4 along an A-A direction according to still another embodiment of the present disclosure.

In the drawings:
1, rotating shaft assembly; 2, electronic device; 3, housing; 4, flexible screen; 10, base; 11, rotating space; 110, second rotating portion; 12, receiving space; 20, first rotating member; 201, first connecting end; 202, second connecting end; 203, mounting face; L1, first rotation axis; L2, second rotation axis; 21, mounting portion; 22, connecting portion; 220, first rotating portion; 23, raised portion; 30, second rotating member; 31, anti-collision gap; 32, second sliding portion; 40, third rotating member; L3, third axis; 41, first sliding portion; 50, synchronizing member; 51, first mating portion; 510, first bulge; 511, peak; 60, first rotating shaft; 600, flat structure; 601, snap slot; 61, sliding member; 62, second mating portion; 620, second bulge; 63, blocking member; 64, first elastic member; 65, second rotating shaft; 66, second elastic member; 67, friction member; 68, mounting member; 69, snap member; 70, first support; 71, bracket; 72, third elastic member; 80, second support; 81, supporting portion; 810, through hole; 82, sliding portion; 821, first part; 822, second part; 823, third part; 90, installing member; 91, installing space; 92, accommodating space.

### DETAILED DESCRIPTION

Some embodiments of the present disclosure are provided in the following. It is to be noted that, any improvement or modification made by a person of ordinary skills in the art, without departing from the principle of the present disclosure, falls within the scope of protection of the present disclosure.

A rotating shaft assembly for an electronic device may be provided by some embodiments of the present disclosure. The electronic device includes a flexible screen and two housings. The rotating shaft assembly includes a base and two first rotating members that rotate in opposite directions. Each of the two first rotating members includes a first connecting end and a second connecting end disposed opposite to the first connecting end. The first connecting end is rotatably connected to the base. The second connecting end is configured to be rotatably connected to a corresponding one of the two housings. Each of the two first rotating members is configured to cooperate with a corresponding one of the two housings that is rotatable about a first rotation axis to support the flexible screen.

Along a direction substantially parallel to an arrangement direction of second rotation axes of the two first rotating members, the first rotation axes of the two housings are located between the second rotation axes of the two first rotating members. The rotating shaft assembly has a folded state where a distance between the first connecting ends of the two first rotating members is greater than a distance between the second connecting ends of the two first rotating members.

In some embodiments, when the rotating shaft assembly is in the folded state, along a direction substantially perpendicular to the arrangement direction of the second rotation axes of the two first rotating members, each of the second rotation axes is disposed closer to a corresponding one of the second connecting ends than a corresponding one of the first rotation axes.

In some embodiments, the rotating shaft assembly further includes two second rotating members. An end of each of the two second rotating members is rotatably connected to the second connecting end of a corresponding one of the two first rotating members. Another end of each of the two second rotating members is configured to be connected to a corresponding one of the two housings.

In some embodiments, each of the two first rotating members includes a mounting face that is configured to mount the flexible screen and at least a part of each of the two second rotating members is disposed at a side adjacent to a surface of a corresponding one of the two first rotating members opposite to the mounting face.

In some embodiments, a rotating space is defined on a side of the base. Each of the two first rotating members includes a mounting portion and a connecting portion disposed on a side of the mounting portion. The connecting portion includes the first connecting end. The mounting portion includes the two second connecting end. A first rotating portion is disposed on an outer peripheral sidewall of the connecting portion. A second rotating portion is disposed on an inner sidewall of the rotating space. The first rotating portion and the second rotating portion are configured to cooperate with one another to enable the two first rotating members to be rotatably connected to the base.

In some embodiments, the rotating shaft assembly further includes two third rotating members. A third axis of each of the two third rotating members is spaced apart from the first rotation axis of a corresponding one of the two housings. An end of each of the two third rotating members is rotatably connected to the base. Another end of each of the two third rotating members is configured to be slidably connected to a corresponding one of the two housings or a corresponding one of the two second rotating members. The two third rotating members are enabled to be driven by the two housings to rotate and to slide with respect to the two housings or the two second rotating members.

In some embodiments, the rotating shaft assembly further includes a synchronizing member. An end of the synchronizing member is rotatably connected to one of the two third rotating members. Another end of the synchronizing member is rotatably connected to the other one of the two third rotating members.

In some embodiments, the synchronizing member and the two third rotating members are disposed on a same side of the base. A first mating portion is disposed on at least one of the synchronizing member and the two third rotating members at a side away from the base. The rotating shaft assembly further includes at least one first rotating shaft, a sliding member, a blocking member, and a first elastic member. The at least one first rotating shaft is connected to the base and penetrates the first mating portion and the at least one of the synchronizing member and the two third rotating members on which the first mating portion is disposed. The sliding member is sleeved on the at least one first rotating shaft and disposed on a side of the first mating portion away from the base. A second mating portion is disposed on a side of the sliding member that faces the first mating portion. The blocking member is fixed to the at least one first rotating shaft and disposed on a side of the sliding member away from the base. The first elastic member is sleeved on the at least one first rotating shaft and disposed between the sliding member and the blocking member. Each of the two third rotating members is configured to rotate synchronously along with the corresponding one of the two housings and further drive the first mating portion to rotate. The first mating portion and the second mating portion are configured to mate with each other to enable the sliding member to slide in a direction toward or away from the two third rotating members. When the sliding member slides in a direction away from the two third rotating members, the first elastic member is in a compressed state that enables the second mating portion to abut against the first mating portion and the two third rotating members to be turned into a stable state after the two third rotating members stop rotating.

In some embodiments, the first mating portion includes a plurality of first bulges that are spaced apart from one another. The second mating portion includes a plurality of second bulges that are spaced apart from one another A plurality of peaks are defined on the plurality of first bulges and the plurality of second bulges. When the sliding member slides in a direction away from the two third rotating members and the plurality of peaks on the plurality of first bulges are in contact with the plurality of peaks on the plurality of second bulges, the first elastic member is in the compressed state that enables the second mating portion to abut against the first mating portion.

In some embodiments, the first elastic member is disposed in a pre-compression state between the sliding member and the blocking member

In some embodiments, the rotating shaft assembly further includes a second rotating shaft and a second elastic member. The second rotating shaft is connected to the base, and penetrates at least one of the synchronizing member and the two third rotating members that is free of being penetrated by the at least one first rotating shaft. The sliding member is sleeved on the second rotating shaft and the blocking member is fixed to the second rotating shaft. The second elastic member is sleeved on the second rotating shaft and disposed between the blocking member and the sliding member. When the sliding member slides in a direction away from the two third rotating members, the second elastic member is in the compressed state that enables the second mating portion to abut against the first mating portion.

In some embodiments, the rotating shaft assembly further includes a friction member disposed on a side of the blocking member away from the base. A flat structure is arranged on at least a part of an outer peripheral side of the at least one first rotating shaft. The friction member and the at least one of the synchronizing member and the two third rotating members on which the first mating portion is disposed are sleeved on the flat structure. The at least one first rotating shaft and the friction member are enabled to be driven by the first mating portion to rotate.

In some embodiments, the rotating shaft assembly further includes a mounting member. The mounting member is fixed to the at least one first rotating shaft and is disposed on a side of the blocking member away from the base. The number of the friction member is two, one friction member is disposed between the blocking member and the mounting member, and the other friction member is disposed on a side of the mounting member away from the blocking member.

In some embodiments, a snap slot is defined on a periphery of an end of the at least one first rotating shaft at a side of the blocking member away from the base. The rotating shaft assembly further includes a snap member. A part of the snap member is disposed in the snap slot.

An electronic device is further provided by some embodiments of the present disclosure. The electronic device includes a flexible screen, two housings, and a rotating shaft assembly. At least a part of one of the two housings and at least a part of the other one of the two housings are disposed on opposite sides of the rotating shaft assembly. The rotating shaft assembly includes a base and two first rotating members that rotate in opposite directions. Each of the two first rotating members includes a first connecting end and a second connecting end disposed opposite to the first connecting end. The first connecting end is rotatably connected to the base. The second connecting end is configured to be rotatably connected to a corresponding one of the two housings. Each of the two first rotating members is configured to cooperate with a corresponding one of the two housings that is rotatable about a first rotation axis to support the flexible screen. Along a direction substantially parallel to an arrangement direction of second rotation axes of the two first rotating members, the first rotation axes of the two housings are located between the second rotation axes of the two first rotating members. The rotating shaft assembly has a folded state where a distance between the first connecting ends of the two first rotating members is greater than a distance between the second connecting ends of the two first rotating members.

In some embodiments, the electronic device further includes a first support. The first support is disposed between the two first rotating members and configured to abut against the flexible screen. A raised portion is disposed on a side of each of the two first rotating members that faces the other one of the two first rotating members. The electronic device has an unfolded state where an extending direction of each of the two first rotating members is substantially parallel to an arrangement direction of the two first rotating members. When the electronic device is in the unfolded state, the first support abuts against the raised portion. When the raised portion rotates, the first support is driven by the raised portion to move along a direction toward the base. After the first support abuts against the base, the first support is separated from the raised portion.

In some embodiments, the electronic device further includes a bracket and a third elastic member. The bracket is disposed on a side of the first support away from the flexible screen and connected to the first support. The third elastic member is disposed between the bracket and the base. When the raised portion rotates, the third elastic member is in a deformation state that enables the third elastic member to drive the first support to move along a direction toward the base through a bouncing force.

In some embodiments, a receiving space is defined on a side of the base away from the rotating space. The third elastic member and at least a part of the bracket are disposed in the receiving space. The third elastic member is disposed on an inner sidewall of the receiving space.

In some embodiments, the third elastic member is disposed in a pre-deformation state between the base and the bracket. When the first support abuts against the base, the third elastic member remains in the deformation state.

In some embodiments, the electronic device further includes a second support. The second support includes a supporting portion and a sliding portion slidably connected to the supporting portion. The supporting portion is connected to the two first rotating members and the sliding portion is configured to be connected to the flexible screen. The electronic device has an unfolded state where an extending direction of each of the two first rotating members is substantially parallel to an arrangement direction of the two first rotating members. When the electronic device is in the unfolded state, a sliding direction of the sliding portion is substantially parallel to the arrangement direction of the two first rotating members.

In some embodiments, a through hole is defined on the supporting portion. The sliding portion includes a first part, a second part, and a third part. The first part and the second part are disposed on opposite sides of the supporting portion. The first part is configured to be connected to the flexible screen. A size of the second part is greater than a size of the through hole. The third part penetrates the through hole to connect the first part and the second part.

In some embodiments, the electronic device further includes an installing member. The installing member defines an installing space. At least a part of the rotating shaft assembly is disposed in the installing space. The electronic device has an unfolded state where an extending direction of each of the two first rotating members is substantially parallel to an arrangement direction of the two first rotating members. When the electronic device is in the unfolded state, an accommodating space is defined by the two housings and the installing member is disposed in the accommodating space.

Prior to introducing the technical solutions of some embodiments of the present disclosure, some technical problems in the related art are introduced in detail.

The rotating shaft assembly, due to a rotational function, may be applied in a variety of fields, such as a field of door locks, a field of vehicles, a field of mechanical engineering, a field of electronic devices, and so on. The rotating shaft assembly includes two first rotating members. Each of the two first rotating members is connected to one component so that a relative rotation of the two components may be realized through the rotating shaft assembly. The following are illustrated by taking a rotating shaft assembly applied to a flexible electronic device as an example.

A flexible screen, as an important part of the flexible electronic device, is an important technical application of an organic light-emitting diode (OLED) and has undergone an important development in recent years. Compared to a conventional display screen, the flexible screen has a thinner and lighter screen, a lower power consumption, and other advantages. Due to the bendability, flexibility, and other characteristics, application scenarios of the flexible screen become wider and wider. For example, some cell phones that apply the flexible screen have been mass-produced and sold in the market. However, the flexible screen itself is a thin flexible light-emitting layer that has to rely on a structure with a certain degree of rigidity to facilitate use in the application scenario. In this way, in terms of the structure, the bending of the flexible screen relies on a hard housing. Two housings are connected to each other through the rotating shaft assembly. The flexible screen is deformed as the two housings and the rotating shaft assembly move, thereby realizing a switch between an unfolded state and a folded state. That is to say, a deformation process of the flexible screen may refer to a movement process of the rotating shaft assembly.

So far, the deformation of the flexible screen is achieved by an inward folding and an outward folding. The inward folding refers to display surfaces of the two halves of the flexible screen moving closer to each other and the rotating shaft assembly being in the folded state, i.e., the flexible screen being hidden by the two housings. The inward folding has an advantage in allowing the two housings to effectively protect the flexible screen through reducing effects of external impacts and wear-and-tear. The outward folding refers to the two housings moving closer to each other and the rotating shaft assembly being in the folded state, i.e., the flexible screen being exposed. The outward folding has an advantage in avoiding the flexible screen from being bent at an angle that is excessively small and allowing a user to use only one half of the screen without having to unfold the flexible screen. With regard to the inward folding, after the flexible screen is folded inwardly, i.e., the rotating shaft assembly and the electronic device are both in the folded state, the flexible screen may be in a U shape or in a waterdrop shape. A U-shaped screen refers to the flexible screen having the shape resembling the letter "U" when viewed from the side, i.e., the two halves of the flexible screen have a certain gap therebetween. A waterdrop shaped screen refers to the flexible screen having the shape resembling a waterdrop when viewed from the side. The waterdrop shaped screen allows parts of the two halves of the flexible screen that are away from the rotating shaft assembly side to be closely in contact with one another after the flexible screen is folded, thereby eliminating the gap between the two halves of the flexible screen, enhancing the visual performance, reducing a risk of damage to the flexible screen, and thus effectively protecting the flexible screen. Therefore, the waterdrop shaped screen is highly popular among a variety of users nowadays.

However, to allow the two halves of the flexible screen to be closely in contact with one another after the flexible screen is folded, more factors in terms of the rotating shaft assembly need to be taken into consideration. In this way, a structure of the rotating shaft assembly in the related art is greatly complicated. That is, a large number of components are required by the rotating shaft assembly, which results in frequent component cooperation, great difficulty in controlling the components, and a relatively high cost, thereby hindering the popularization of the electronic device.

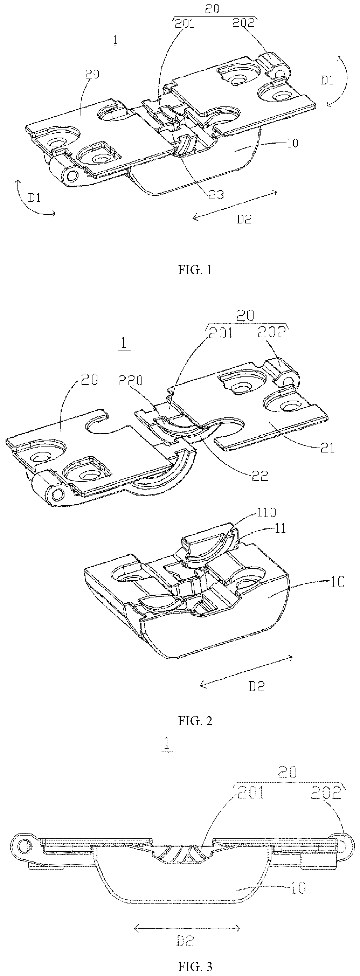

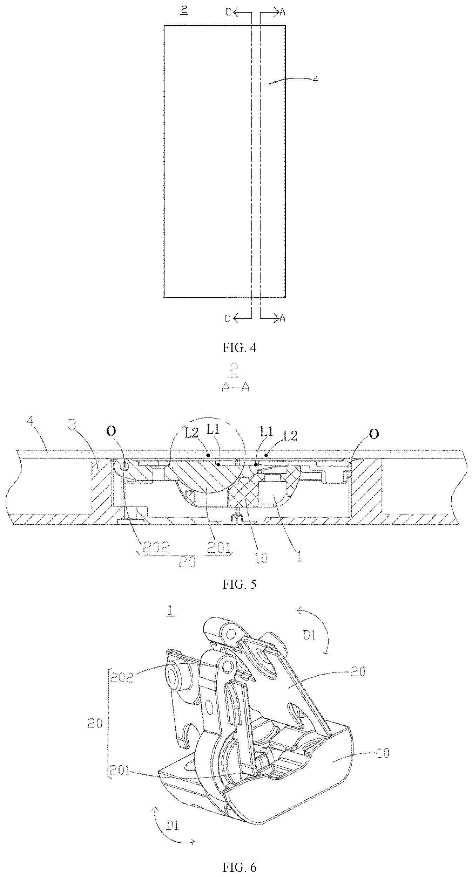

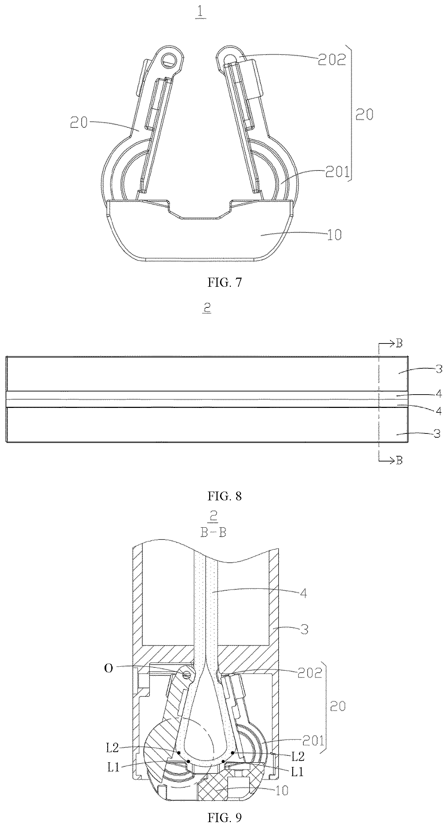

Therefore, to address the technical problems above, a rotating shaft assembly and an electronic device are provided by some embodiments of the present disclosure. As illustrated in FIGS. 1-9, FIG. 1 is a schematic perspective structural view of a rotating shaft assembly in an unfolded state according to an embodiment of the present disclosure. FIG. 2 is an exploded schematic view of FIG. 1. FIG. 3 is a side elevational view of FIG. 1. FIG. 4 is a top plan view of a rotating shaft assembly when the rotating shaft assembly is configured in an electronic device and in an unfolded state according to an embodiment of the present disclosure. FIG. 5 is a partial cross-sectional view of the rotating shaft assembly illustrated in FIG. 4 along an A-A direction according to an embodiment of the present disclosure. FIG. 6 is a schematic perspective structural view of a rotating shaft assembly in a folded state according to an embodiment of the present disclosure. FIG. 7 is a side elevational view of FIG. 6. FIG. 8 is a top plan view of a rotating shaft assembly when the rotating shaft assembly is configured in an electronic device and in a folded state according to an embodiment of the present disclosure. FIG. 9 is a partial cross-sectional view of the rotating shaft assembly illustrated in FIG. 8 along a B-B direction according to an embodiment of the present disclosure.

A rotating shaft assembly 1 for an electronic device 2 is provided by some embodiments of the present disclosure. The electronic device 2 includes a flexible screen 4 and two housings 3. The rotating shaft assembly 1 includes a base 10 and two first rotating members 20 that rotate in opposite directions. Each first rotating member 20 includes a first connecting end 201 and a second connecting end 202 that is disposed in opposite to the first connecting end 201. The first connecting end 201 is rotatably connected to the base 10 and the second connecting end 202 is configured to be rotatably connected to the corresponding housing 3. The first rotating member 20 is configured to cooperate with the corresponding housing 3 that is rotatable about or around a first rotation axis L1 to support the flexible screen 4. Along a direction substantially parallel to an arrangement direction of second rotation axes L2 of the two first rotating members 20, the first rotation axes L1 of the two housings 3 are located between the second rotation axes L2 of the two first rotating members 20. The rotating shaft assembly 1 has a folded state where a distance between the first connecting ends 201 of the two first rotating members 20 is greater than a distance between the second connecting ends 202 of the two first rotating members 20.

The present embodiment is illustrated by taking the rotating shaft assembly 1 applied to the flexible electronic device 2 as an example. The rotating shaft assembly 1 is configured to cooperate with the housing 3 of the electronic device 2 to enable the flexible screen 4 to rotate in a predetermined way, thereby obtaining a desired shape of the flexible screen 4. Thus, the electronic device 2 may further refer to a flexible electronic device. In some embodiments, the electronic device 2 includes the flexible screen 4 and the two housings 3. However, the electronic device 2 may further include other components, such as a circuit board, a battery, a camera, etc., except the flexible screen 4 and the housing 3. The present disclosure only introduces a relationship between the rotating shaft assembly 1 and the flexible screen 4, and between the rotating shaft assembly 1 and the housing 3, merely because the flexible screen 4 and the housing 3 are components that are greatly relevant to the rotating shaft assembly 1 according to some embodiments of the present embodiment.

The rotating shaft assembly 1 includes the base 10. In some embodiments, the base 10 may be configured to support and connect other components, thereby serving as a fundamental component of the rotating shaft assembly 1. A material of the base 10 includes, but is not limited to, a plastic, a metal, and etc., which is not limited herein, as long as enabling the base 10 to mount other components.

The rotating shaft assembly 1 further includes the two first rotating members 20 in addition to the base 10. Each first rotating member 20 is rotatably connected to the base 10. That is, the first rotating member 20 is rotatable with respect to the base 10 and the flexible screen 4 may be driven by the first rotating member 20 to rotate. A shape, a structure, a material, and other parameters of the first rotating member 20 are not limited herein, as long as enabling the first rotating member 20 to be rotatable.

The two first rotating members 20 rotate in opposite directions. A rotation direction of each of the two first rotating members 20 is illustrated by D1 in FIG. 1. In some embodiments, when one of the two first rotating members 20 rotates clockwise, the other one of the two first rotating members 20 rotates counterclockwise. In some embodiments, when one of the two first rotating members 20 rotates counterclockwise, the other one of the two first rotating members 20 rotates clockwise. In this way, the two first rotating members 20 may get closer to each other when rotate, which allows two halves of the flexible screen 4 to be closely in contact with each other, thereby providing a fundamental of movement to realize the folded state later.

In some embodiments, the two first rotating members 20 being disposed in opposite to each other may refer to at least a part of one of the two first rotating members 20 being spaced apart from at least a part of the other one of the two first rotating members 20, i.e., the two rotating members 20 are at least partially spaced apart from each other. That is, one of the two first rotating members 20 is a certain distance away from the other one of the two first rotating members 20, which reduces a chance of collision between the two first rotating members 20 when the two first rotating members 20 rotate, facilitating a connection between the first rotating member 20 and another component, and further reserving a mounting space for other components, e.g., a first support. In some embodiment, the two first rotating members 20 may abut against each other. The present embodiment is merely illustrated by taking the two first rotating members 20 being disposed in opposite to each other as an example.

In some embodiments, the two first rotating members 20 are substantially symmetrically arranged, which simplifies the structure of the rotating shaft assembly 1, saves the cost, and improves a consistency of rotation when the two first rotating members 20 rotate. In some embodiments, one of the two first rotating members 20 extends in a direction away from the other one of the two first rotating members 20. Furthermore, in some embodiment, the two first rotating members 20 are substantially arranged in central symmetry, which allows a part of one of the two first rotating members 20 and a part of the other one of the two first rotating members 20 to be disposed on a same area of the base 10, thereby reducing the size of the rotating shaft assembly 1 and allowing the structure of the rotating shaft assembly 1 to be more compact. In addition, the same area where the part of one of the two first rotating members 20 and the part of the other one of the two first rotating members 20 are disposed on may further configured to support other components, e.g., the first support. A way how the first support is supported by the first rotating member will be illustrated herein later.

The first rotating member 20 is rotatably connected to the base 10, which allows the first rotating member 20 to rotate with respect to the base 10, thereby further changing an angle between the base 10 and the first rotating member 20. Besides, each first rotating member 20 is further rotatably connected to the corresponding housing 3, which allows the first rotating member 20 to rotate with respect to the corresponding housing 3, thereby further changing an angle between the first rotating member 20 and the corresponding housing 3. In other words, each first rotating member 20 is connected to the corresponding housing 3, which avoids the first rotating member 20 and the corresponding housing 3 being separated from each other when rotate. Since the first rotating member 20 is rotatably, rather than fixedly, connected to the housing 3, the first rotating member 20 is rotatable about a connecting point O (as illustrated in FIG. 5 and FIG. 9), which allows an angle between the first rotating member 20 and the corresponding housing 3 to be changed. The connecting point O is connected between the rotating member 20 and the corresponding housing 3.

In addition, for each first rotating member 20, the first rotating member 20 includes the first connecting end 201 and the second connecting end 202 disposed in opposite to the first connecting end 201. The first connecting end 201 is configured to be rotatably connected to the base 10 and the second connecting end 202 is configured to be rotatably connected to the corresponding housing 3. An extending direction (as illustrated by D2 in FIGS. 1-3) of the first rotating member 20 may refer to a direction from the first connecting end 201 to the second connecting end 202 or a direction from the second connecting end 202 to the first connecting end 201.

In some embodiments, for each first rotating member 20, the first rotating member 20 may be directly connected to the corresponding housing 3. That is, the first rotating member 20 is directly rotatably connected to the housing 3. In some embodiments, the first rotating member 20 may be indirectly rotatably connected to the housing 3, i.e., the first rotating member 20 is rotatably connected to the housing 3 through another component, such as a second rotating member. That is, the first rotating member 20 is rotatably connected to the another component and the another component is further connected to the housing 3, which reduces the difficulty in manufacturing the housing 3. The technical solution of the present embodiment may be realized through the existing structure of the housing 3. Furthermore, in some embodiments, a shape, a structure, a material, and other parameters of the housing 3 are not limited herein, as long as enabling the housing 3 to be rotatably connected to the first rotating member 20 and to drive the corresponding first rotating member 20 to rotate. In some embodiments, the housing 3 may include, but not be limited to, a middle frame, a back cover, and so on.

With regard to the flexible screen 4, the flexible screen 4 may be disposed on the same side of the two housings 3 and the two first rotating members 20, which enables the flexible screen 4 to be driven by the housings 3 and the first rotating members 20 to rotate when the housing 3 and the first rotating member 20 rotate. In some embodiments, the flexible screen 4 may be directly disposed on the housings 3 and the first rotating members 20. In some embodiments, the flexible screen 4 may be disposed on another component and the another component is further disposed on at least one of the housings 3 and the first rotating members 20. An arrangement of the flexible screen 4 is not limited herein, as long as enabling the flexible screen 4 to be movable along with the housings 3 and the first rotating members 20.

For each housing 3, the housing 3 may be rotated by an external force provided by the user or other components. Since the first rotating member 20 is connected to the housing 3, when the housing 3 rotates, the housing 3 and the first rotating member 20 may not be separated from one another and the housing 3 may drive the corresponding first rotating member 20 to rotate. As illustrated in FIG. 5 and FIG. 9, when the housing 3 rotates, the housing 3 rotates about a corresponding first rotation axis L1 and the first rotating member 20 rotates about a corresponding second rotation axis L2. In other words, when the housing 3 is rotatable along a rotation direction about a rotation center, the corresponding first rotation axis L1 may refer to an extension line of the rotation center along a direction perpendicular to the rotation direction of the housing 3. A position of the first rotation axis L 1 is not limited herein and may be determined based on an actual product design. Similarly, when the first rotating member 20 is rotatable along a rotation direction about a rotation center, the corresponding second rotation axis L2 may refer to an extension line of the rotation center along a direction perpendicular to the rotation direction of the first rotating member 20. A position of the second rotation axis L2 is not limited herein and may be determined based on an actual product design. The dashed circle in FIG. 5 and FIG. 9 refers to a moving path of the first connecting end 201 about the corresponding second rotation axis L2.

In addition, relationships between the first rotation axis L 1 and the second rotation axis L2 are defined herein. Since the electronic device 2 includes the two first rotating members 20 and the two housings 3, two first rotation axes L 1 and two second rotation axes L2 are thus defined correspondingly to the two first rotating members 20 and the two housings 3. In some embodiments, along a direction substantially parallel to an arrangement direction of the two second rotation axes L2, the two first rotation axes L1 are located between the two second rotation axes L2. That is, orthographic projections of the two first rotation axes L1 on a plane formed by the two second rotation axes L2 are located between the two second rotation axes L2. In other words, the two first rotation axes L1 do not overlap the two second rotation axes L2, i.e., the rotation centers of the two housings 3 do not overlap the rotation centers of the two first rotating members 20. The rotation centers of the two housings 3 are arranged closer to a center of the base 10 than the rotation centers of the two first rotating members 20. That is to say, the two first rotation axes L1 are arranged on the inner side of the two second rotation axes L2 and the two second rotation axes L2 are arranged on the outer side of the two first rotation axes L1. The above relationships between the first rotation axis L1 and the second rotation axis L2 provide a fundamental for the subsequent movement.

The waterdrop shaped screen formed by two halves of the flexible screen may be realized based on the aforementioned positional relationships and connecting relationships determined for the above structures. In some embodiments, when the rotating shaft assembly 1 is applied to or configured in the electronic device 2, the electronic device 2 may have several different states, such as an unfolded state and a folded state. It should be noted that, since the rotating shaft assembly 1 is applied to the electronic device 2, when the electronic device 2 has the unfolded state and the folded state, the rotating shaft assembly 1 may further have the unfolded state and the folded state correspondingly. That is to say, the unfolded state of the electronic device 2 may refer to the unfolded state of the rotating shaft assembly 1 and the folded state of the electronic device 2 may refer to the folded state of the rotating shaft assembly 1. The unfolded state of the electronic device 2 refers to the flexible screen 4 being flat, i.e., a state where an entire surface of the flexible screen 4 is flat. In some embodiments, the flexible screen 4 may be divided into a left-half screen and a right-half screen. In this way, the unfolded state of the electronic device 2 refers to a state where an angle between the left-half screen of the flexible screen 4 and the right-half screen of the flexible screen 4 is 180 degrees. The folded state of the electronic device 2 refers to a state where the flexible screen 4 is driven by the first rotating member 20 and the housing 3 to rotate by 90 degrees. In this case, a part of the left-half screen of the flexible screen 4 is substantially parallel to a part of the right-half screen of the flexible screen 4. In addition, another part of the left-half screen of the flexible screen 4 and another part of the right-half screen of the flexible screen 4 are closely in contact with each other, i.e., an included angle therebetween is 0 degree. The unfolded state of the rotating shaft assembly 1 is a state where an extending direction of each first rotating member 20 is substantially parallel to an arrangement direction of the two first rotating members 20. The folded state of the rotating shaft assembly 1 is a state where a distance between the first connecting ends 201 of the two first rotating members 20 is greater than a distance between the second connecting ends 202 of the two first rotating members 20 and an included angle between the two first rotating members 20 is greater than 0 degree. That is to say, the two first rotating members 20 are not in parallel, rather an angle is formed by the two first rotating members 20.

As illustrated in FIG. 5 and FIG. 9, when the electronic device 2 is switching from the unfolded state to the folded state, the housing 3 rotates about the corresponding first rotation axis L1 due to the external force applied by the user or other components on the housing 3. Since the housing 3 is rotatably connected to the first rotating member 20 and the first rotation axis L 1 is not located at the connecting point O, when the housing 3 rotates, the corresponding first rotating member 20 rotates along with the housing 3 about the corresponding second rotation axis L2 with respect to the base 10. When the housing 3 rotates by a certain degree, the corresponding connecting point O substantially rotates by the same degree. Since the first rotation axis L1 does not overlap the second rotation axis L2, when the first rotating member 20 rotates by the same degree as the corresponding housing 3 and stop, the second connecting end 202 of the first rotating member 20 may not reach the corresponding connecting point O. Since the first rotation axis L1 is arranged closer to the center of the base 10 than the second rotation axis L2, an angle rotated by the first rotating member 20 has to be greater than an angle rotated by the corresponding housing 3, in order to ensure the first rotating member 20 to remain connected to the housing 3.

Therefore, when the electronic device 2 is in the folded state, the two halves of the flexible screen 4 are attached to each other on a side away from the base 10. In other words, each of the left-half screen of the flexible screen 4 and the right-half screen of the flexible screen 4 is driven by a corresponding housing 3 to rotate by 90 degrees, thereby switching the flexible screen 4 from being arranged horizontally to being arranged vertically and allowing a part of the left-half screen of the flexible screen 4 and a part of the right-half screen of the flexible screen 4 to be attached to each other. Furthermore, when the electronic device 2 is in the folded state, the two housings 3 are substantially parallel to each other, i.e., an angle between the two housings 3 is 0 degree. In some embodiments, an angle rotated by the first rotating member 20 has to be greater than an angle rotated by the corresponding housing 3, for example, greater than 90 degrees, to ensure that an angle between the two first rotating members 20 is greater than 0 degree, which further ensures the first rotating member 20 to remain rotatably connected the housing 3. That is to say, when the electronic device 2 is in the unfolded state, each first rotating member 20 and the corresponding housing 3 are substantially in parallel, i.e., an included angle between each first rotating member 20 and the corresponding housing 3 is substantially 180 degrees. When the electronic device 2 is in the folded state, the included angle between each first rotating member 20 and the corresponding housing 3 is greater than 180 degrees. In this way, a distance between the first connecting ends 201 of the two first rotating members 20 that are close to the base 10 is greater than a distance between the second connecting ends 202 of the two first rotating members 20 that are away from the base 10, thereby realizing the folded state of the rotating shaft assembly 1 where a space formed by the two first rotating members 20 is narrow at the top and wide at the bottom. Therefore, a space that is narrow at the top and wide at the bottom is formed by parts of the two halves of the flexible screen 4 that are not in contact with each other, which enables the shape of the flexible screen 4 to resemble a waterdrop. Thus, the flexible screen 4 may further refer to the waterdrop shaped screen.

In addition, within the space formed by the two first rotating members 20 when rotating shaft assembly 1 is in the folded state, the flexible screen 4 may have more room to bend on a side of the space close to the base 10, i.e., at a lower end of the flexible screen 4. In other words, a bending radius at the lower end of the flexible screen 4 is greater than a bending radius at an upper end of the flexible screen 4, which avoids an excessive concentration of stress at a bending point of the flexible screen 4, thereby reducing the number of creases even eliminating the creases formed after the flexible screen 4 is bent and improving a performance and a service life of the flexible screen 4.

In summary, some embodiments of the present disclosure may realize the waterdrop shaped screen through the rotating shaft assembly 1 that only includes three components, i.e., the base 10 and the two first rotating members 20. That is, when the rotating shaft assembly 1 is applied to the electronic device 2, a waterdrop shape screen where the two halves of the flexible screen 4 are closely in contact with each other in the folded state may be realized merely through designing the positional relationship between the axis of the first rotating member 20 and the axis of the housing 3. Besides, the bending radius at the lower end of the flexible screen 4 may be further increased. In this way, the structure of the rotating shaft assembly 1 is simplified, the cost of the rotating shaft assembly 1 is saved, and the number, the weight, and etc. of the components required by the rotating shaft assembly 1 are reduced. In addition, the component cooperation is less frequent and the control of the components is less difficult, thereby facilitating the popularization of the electronic device 2. Furthermore, the number of creases may be reduced or the creases may be even eliminated to improve the performance and the service life of the flexible screen 4.

In some embodiments, from the perspective of an actual production, a particular rotation angle of the first rotating member 20 may be adjusted through controlling the position of the first rotation axis L 1 and the second rotation axis L2, which further adjusts the shape of the waterdrop shaped screen.

As further illustrated in FIG. 5 and FIG. 9, in some embodiments, when the rotating shaft assembly 1 is in the folded state, along a direction substantially perpendicular to an arrangement direction of the second rotation axes L2 of the two first rotating members 20, the second rotation axis L2 is disposed closer to a corresponding second connecting end 202 than a corresponding first rotation axis L 1.

The positional relationship between the first rotation axis L1 and the second rotation axis L2 may be further defined in terms of other directions, in addition to the first rotation axes L1 of the two housings 3 being located between the second rotation axes L2 of the two first rotating members 20 along a direction substantially parallel to an arrangement direction of the second rotation axes L2 of the two first rotating members 20. Along a direction substantially perpendicular to an arrangement direction of the second rotation axes L2 of the two first rotating members 20, the second rotation axis L2 of each first rotating member 20 is arranged at a level higher than the level at which the first rotation axis L1 of the corresponding housing 3 is arranged. In other words, when the rotating shaft assembly 1 is in the folded state, the second rotation axis L2 is disposed closer to the corresponding second connecting end 202 than the corresponding first rotation axis L 1.

Along a direction substantially parallel to an arrangement direction of the second rotation axes L2 of the two first rotating members 20, i.e., along a horizontal direction, the first rotation axes L1 of the two housings 3 are located between the second rotation axes L2 of the two first rotating members 20. That is, the first rotation axis L1 is arranged relatively closer to the center of the base 10 than the second rotation axis L2. In this way, a distance between the first rotation axis L1 and the corresponding connecting point O is greater than a distance between the second rotation axis L2 and the corresponding connecting point O. After the housing 3 and the corresponding first rotating member 20 rotate by a certain angle, along a direction substantially perpendicular to an arrangement direction of the second rotation axes L2 of the two first rotating members 20, i.e., along a vertical direction, a change in height of the housing 3 is greater than a change in height of the corresponding first rotating member 20. Therefore, in some embodiments, the first rotation axis L1 is arranged above the second rotation axis L2. In this way, when the electronic device 2 is switching from the unfolded state to the folded state, along a direction substantially perpendicular to an arrangement direction of the second rotation axes L2 of the two first rotating members 20, a change in height of the housing 3 is enabled to be substantially equal to a change in height of the corresponding first rotating member 20, thereby ensuring the housing 3 to remain rotatably connected to the first rotating member 20.

The difference between the change in height of the housing 3 and the change in height of the corresponding first rotating member 20 may be addressed through technical solutions provided by other embodiments of the present disclosure. In some embodiments, a size of the first rotating member 20 is adjustable along an extending direction thereof, i.e., the first rotating member 20 is extendable or retractable along the extending direction thereof. After the housing 3 rotates by a certain angle, the corresponding first rotating member 20 may be capable of not only continuing to rotate by a greater angle but also extending or retracting adaptively to compensate a displacement difference between the housing 3 and the corresponding first rotating member 20 along the vertical direction, which ensures the housing 3 to remain rotatably connected to the first rotating member 20.

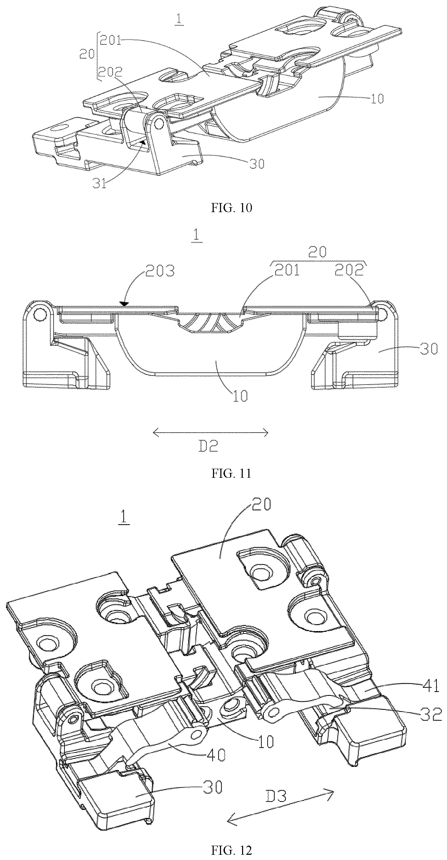

As illustrated in FIG. 10 and FIG. 11, FIG. 10 is a schematic perspective structural view of a rotating shaft assembly according to another embodiment of the present disclosure. FIG. 11 is a side elevational view of FIG. 10. In some embodiments, the rotating shaft assembly 1 further includes two second rotating members 30. An end of the second rotating member 30 is rotatably connected to the second connecting end 202. Another end of the second rotating member 30 is configured to be connected to the housing 3.

The rotating shaft assembly 1 further includes the second rotating members 30 in addition to the base 10 and the first rotating members 20. For each second rotating member 30, an end of the second rotating member 30 is rotatably connected to the second connecting end 202 of the first rotating member 20. Another end of the second rotating member 30 is capable of being connected to the housing 3. When the first rotating member 20 rotates with respect to the corresponding second rotating member 30, the first rotating member 20 may be understood as rotating with respect to the corresponding housing 3, which enables the first rotating member 20 to be indirectly rotatably connected to the housing 3 and further reduces a design difficulty of the housing 3. Besides, a material, a shape, a structure, and etc. of the second rotating member 30 are not limited herein, as long as enabling the second rotating member 20 to realize the rotation and connection function.

In some embodiments, the second connecting end 202 and the second rotating member 30 may rotate through a rotating shaft. In some embodiments, a rotating hole or rotating recess or groove may be defined on each of the second connecting end 202 and the second rotating member 30. A part of the rotating shaft may be disposed in the corresponding rotating hole or rotating recess, which enables the second connecting end 202 to be rotatably connected to the second rotating member 30.

In some embodiments, a "connection" between the second rotating member 30 and the housing may include, but not be limited to, a fixed connection, a detachable connection, and so on. In case of the fixed connection, the second rotating member 30 and the housing 3 may be implemented as a one-piece structure. That is, the second rotating member 30 and the housing 3 are manufactured through the same process. The second rotating member 30 and the housing 3 are named differently merely for the ease of understanding. In case of the detachable connection, a screw hole is defined on each of the second rotating member 30 and the housing 3 and a screw is disposed in the corresponding screw hole to enable the second rotating member 30 and the housing 3 to be detachably connected to one another In some embodiments, the second rotating member 30 may be detachably connected to the housing 3 through a snap connection or engagement. The connection between the second rotating member 30 and the housing 3 ensures a rotation angle of the second rotating member 30 to be consistent with a rotation angle of the corresponding housing 3. That is, an angle rotated by the second rotating member 30 is substantially equal to an angle rotated by the corresponding housing 3, which reduces wobbles of the housing when rotates and thus improves the stability of the housing when rotates.

In some embodiments, as illustrated in FIG. 11, an end of each of the two first rotating members 20 away from the other one of the two first rotating members 20 protrudes out of the base 10. In other words, the first rotating member 20 protrudes out of the base 10 along the corresponding extending direction, which facilitates the first rotating member 20 to be rotatably connected to the housing or the second rotating member 30. Furthermore, in some embodiments, the second connecting end 202 protrudes out of the base 10.

As further illustrated in FIG. 10, in some embodiments, when the rotating shaft assembly 1 is in the unfolded state, an anti-collision gap 31 is defined between the second rotating member 30 and a surface of the corresponding first rotating member 20 away from a mounting face 203. The unfolded state of the rotating shaft assembly 1 is illustrated in detail above and will not be repeated herein. When the rotating shaft assembly 1 is in the unfolded state, the second rotating member 30 and the first rotating member 20 are arranged along the vertical direction and the anti-collision gap 31 is defined between the second rotating member 30 and a surface of the corresponding first rotating member 20 away from the mounting face 203. That is to say, the second rotating member 30 is at a distance away from the corresponding first rotating member 20. Since an angle rotated by the second rotating member 30 has to be greater than an angle rotated by the corresponding housing 3, the second rotating member 30 may not remain still with respect to the corresponding housing 3. That is, the second rotating member 30 is rotatable with respect to the corresponding housing 3, i.e., the second rotating member 30 may rotate along a direction toward the corresponding first rotating member 20. Therefore, the anti-collision gap 31 is defined between the second rotating member 30 and the corresponding first rotating member 20 in the unfolded state to avoid the rotating shaft assembly 1 from getting stuck during the movement, thereby ensuring a smooth and safe movement of the rotating shaft assembly 1.

As further illustrated in FIG. 11, in some embodiments, each first rotating member 20 includes the mounting face 203. The mounting face 203 is configured to mount the flexible screen 4. At least a part of the second rotating member 30 is disposed at a side adjacent to a surface of the corresponding first rotating member 20 opposite to the mounting face 203.

The first rotating member 20 includes the mounting face 203. The mounting face 203 is configured to mount the flexible screen 4. The flexible screen 4 may be directly disposed on the mounting face 203 or may be indirectly disposed on the mounting face 203 through other components. Therefore, the mounting face 203 may refer to a surface of a side of the first rotating member 20 that is close to the flexible screen 4. In other words, the mounting face 203 is an upper surface of the first rotating member 20.

With regard to a position of the second rotating member 30, at least a part of the second rotating member 30 may be disposed at a side adjacent to a surface of the corresponding first rotating member 20 opposite to the mounting face 203. In other words, along a direction substantially perpendicular to an extending direction of each two first rotating member 20, the first rotating member 20 and at least a part of the corresponding second rotating member 30 are arranged vertically, which reduces the size of the rotating shaft assembly 1 along the extending direction of the two first rotating members 20 and allows the structure of the rotating shaft assembly 1 to be more compact. That is to say, at least a part of the second rotating member 30 is located at a lower surface of the corresponding first rotating member 20.

In addition, the at least a part of the two second rotating member 30 being disposed at a side adjacent to a surface of a side of the corresponding first rotating member 20 opposite to the mounting face 203 mentioned above may further refer to the second rotating member 30 being entirely disposed at the side adjacent to the surface of the corresponding first rotating member 20 opposite to the mounting face 203. In this case, the two second rotating member 30 may further be rotatably connected to the side of the corresponding first rotating member 20 opposite to the mounting face 203. In some embodiments, a part of the second rotating member 30 is disposed at the side adjacent to the surface of the side of the corresponding first rotating member 20 opposite to the mounting face 203 and a remaining part of the second rotating member 30 is disposed at another side of the corresponding first rotating member 20. In this case, the second rotating member 30 may be disposed at an end of a corresponding one of the two first rotating members 20 that is away from the other one of the two first rotating members 20. The present embodiment is merely illustrated by taking a part of each of the two second rotating members 30 being disposed at the same side of the two first rotating members 20 as an example.

As further illustrated in FIG. 2, in some embodiments, a rotating space 11 is defined on a side of the base 10. The first rotating member 20 includes a mounting portion 21 and a connecting portion 22 disposed on a side of the mounting portion 21. The connecting portion 22 includes the first connecting end 201. The mounting portion 21 includes the second connecting end 202. A first rotating portion 220 is disposed on an outer peripheral sidewall of the connecting portion 22. A second rotating portion 110 is disposed on an inner sidewall of the rotating space 11. The first rotating portion 220 and the second rotating portion 110 are configured to cooperate with one another to enable the two first rotating members 20 to be rotatably connected to the base 10.

In addition to the relationship between the first rotating member 20 and the second rotating member 30 and the relationship between the second rotating member 30 and the housing 3, some embodiments of the present disclosure further illustrate a relationship between the base 10 and the first rotating member 20. In some embodiments, the rotating space 11 is defined on a side of the base 10 and at least a part of the first rotating member 20 is disposed in the rotating space 11, which enables the two first rotating member 20 to be rotatably connected to the base 10, thereby reducing an overall thickness of the rotating shaft assembly 1 and realizing a more compact structure of the rotating shaft assembly 1. Besides, the at least a part of the first rotating member 20 being disposed in the rotating space 11 mentioned above may further refer to the first rotating member 20 being entirely disposed in the rotating space 11, which further reduces the overall thickness of the rotating shaft assembly 1. In some embodiments, a part of the first rotating member 20 is disposed in the rotating space 11 and a remaining part of the first rotating member 20 is disposed outside of the rotating space 11, which facilitates subsequent components to be disposed on the first rotating member 20. The present embodiment is merely illustrated by taking at least a part of the first rotating member 20 being disposed in the rotating space 11 as an example.

Each first rotating member 20 may include the mounting portion 21 and the connecting portion 22 disposed on a side of the mounting portion 21. The mounting portion 21 is configured to be connected to not only the connecting portion 22 but also the flexible screen 4. The connecting portion 22 is configured to be rotatably connected to the base 10. In some embodiments, the mounting portion 21 and the connecting portion 22 may be implemented as a one-piece structure or implemented as separate structures. In case of the one-piece structure, the mounting portion 21 and the connecting portion 22 are manufactured through the same process. The mounting portion 21 and the connecting portion 22 are named differently merely for the ease of understanding. In case of the separate structures, the mounting portion 21 and the connecting portion 22 are manufactured independently and further combined together through various means. A cooperation relationship between the mounting portion 21 and the connecting portion 22 is not limited herein. In addition, a material, a shape, and a structure of the mounting portion 21 are not limited herein, as long as enabling the mounting portion 21 to realize the mounting function. The mounting portion 21 includes the second connecting end 202 that is configured to be rotatably connected to the housing 3. The connecting portion 22 includes the first connecting end 201 that is configured to be rotatably connected to the base 10. Since the first connecting end 201 is disposed in opposite to the second connecting end 202, the connecting portion 22 may be understood as being disposed at a side of an end of the mounting portion 21 opposite to the second connecting end 202.

With regard to the connecting portion 22, in some embodiments, the first rotating portion 220 is disposed on the outer peripheral sidewall of the connecting portion 22. The second rotating portion 110 is disposed on the inner sidewall of the rotating space 11. By disposing at least part of the connecting portion 22 in the rotating space 11, the first rotating portion 220 may cooperate with the second rotating portion 110 to enable the first rotating member 20 to be rotatably connected to the base 10. In some embodiments, one of the second rotating portion 110 and the first rotating portion 220 may include a rotating block and the other one of the second rotating portion 110 and the first rotating portion 220 may include a rotating recess. That is, when the first rotating portion 220 includes the rotating block, the second rotating portion 110 includes the rotating recess; and when the first rotating portion 220 includes the rotating recess, the second rotating portion 110 includes the rotating block. The present embodiment is merely illustrated by taking the first rotating portion 220 including the rotating recess and the second rotating portion 110 including the rotating block as an example.

In some embodiments, the mounting portion 21 is disposed outside of the rotating space 11. When the rotating shaft assembly 1 is in the unfolded state, the mounting portion 21 abuts against the base 10, thereby improving the stability of the first rotating member 20 and avoiding the rotating shaft assembly 1 from wobbling randomly. In some embodiments, the mounting portions 21 of the two first rotating members 20 are spaced apart from one another, which not only reduces the chance of collision between the two first rotating members 20 but also reserves the mounting space for subsequent components.

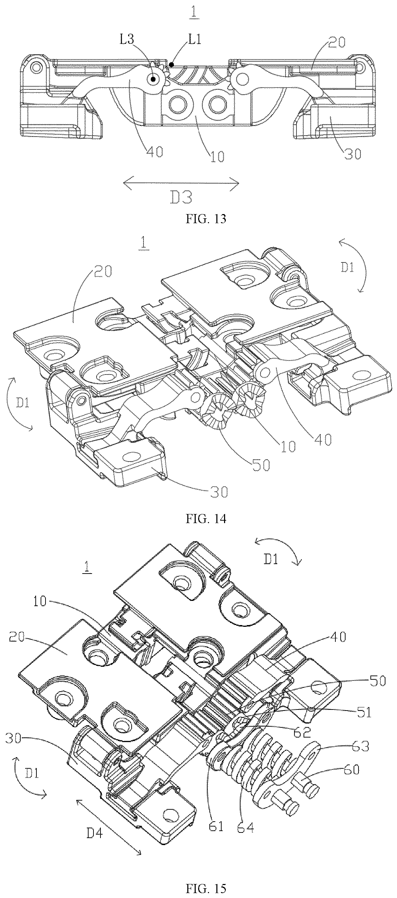

As illustrated in FIG. 12 and FIG. 13, FIG. 12 is a schematic perspective structural view of a rotating shaft assembly according to still another embodiment of the present disclosure. FIG. 13 is a side elevational view of FIG. 12. In some embodiments, the rotating shaft assembly 1 further includes two third rotating members 40. For each third rotating member 40, a third axis L3 of the third rotating member 40 is spaced apart from the first rotation axis L 1. An end of the third rotating member 40 is rotatably connected to the base 10. Another end of the third rotating member 40 is configured to be slidably connected to the housing or the second rotating member 30. Therefore, when the housing rotates, the corresponding third rotating member 40 may be driven by the housing to rotate and slide with respect to the housing or the corresponding second rotating member 30.

The rotating shaft assembly 1 further includes the third rotating member 40, in addition to the first rotating member 20 and the second rotating member 30. The third rotating member 40 is configured to perform a rotation function. A material, a shape, and a structure of the third rotating member 40 are not limited herein, as long as enabling the third rotating member 40 to perform the rotation function. For each third rotating member 40, an end of the two third rotating member 40 is rotatably connected to a side of the base 10. Another end of the third rotating member 40 is slidably connected to the corresponding housing or the corresponding second rotating member 30. In other words, the third rotating member 40 is slidably connected to the housing or slidably connected to the second rotating member 30. The present embodiment is merely illustrated by taking the third rotating member 40 being slidably connected to the second rotating member 30 as an example.

Regardless of whether the third rotating member 40 is slidably connected to the housing or the second rotating member 30, the third rotating member 40 may be driven by the corresponding housing to rotate when the corresponding housing rotates. In some embodiments, when the third rotating member 40 is slidably connected to the housing, the third rotating member 40 is capable of being directly driven by the corresponding housing to rotate. When the third rotating member 40 is slidably connected to the second rotating member 30, the housing 3 is capable of driving the corresponding second rotating member 30 to rotate, thereby further driving the corresponding third rotating member 40 to rotate. The third rotating member 40 is rotatable about the third axis L3. Since the third axis L3 and the first rotation axis L1 of the housing 3 are spaced apart from one another, i.e., the third axis L3 does not overlap the first rotation axis L1, the third rotating member 40 and the housing 3 are not rotate about the same rotation center. In this way, when the third rotating member 40 rotates, the third rotating member 40 may further slide with respect to the corresponding housing 3 or the corresponding first rotating member 20 (a sliding direction may be illustrated by D3 in FIG. 12 and FIG. 13), in order to compensate a displacement difference during the rotation. The third rotating member 40 is arranged to avoid the rotating shaft assembly 1 from being driven to rotate solely by the first rotating member 20. That is, through enabling the third rotating member 40 and the first rotating member 20 to rotate along with one another, the rotation of the rotating shaft assembly 1 may be more stable, thereby avoiding a damage to the first rotating member 20 due to an excessive concentration of stress. In addition, the third rotating member 40 may be further configured to cooperate with other components to realize other functions.

In some embodiments, as illustrated in FIG. 12, for each third rotating member 40, when the third rotating member 40 is slidably connected to the second rotating member 30, the third rotating member 40 includes a first sliding portion 41 and the second rotating member 30 includes a second sliding portion 32. The first sliding portion 41 and the second sliding portion 32 cooperate with each other to enable the third rotating member 40 to be slidably connected to the second rotating member 30. Furthermore, in some embodiments, one of the first sliding portion 41 and the second sliding portion 32 includes a slider and the other one of the first sliding portion 41 and the second sliding portion 32 includes a sliding groove. That is to say, when the first sliding portion 41 includes the slider, the second sliding portion 32 includes the sliding groove; when the first sliding portion 41 includes the sliding groove, the second sliding portion 32 includes the slider. The present embodiment is merely illustrated by taking the first sliding portion 41 including the slider and the second sliding portion 32 including the sliding groove as an example.

As illustrated in FIG. 14, FIG. 14 is a schematic perspective structural view of a rotating shaft assembly according to still another embodiment of the present disclosure. In some embodiments, the rotating shaft assembly 1 further includes a synchronizing member 50. An end of the synchronizing member 50 is rotatably connected to one of the two third rotating members 40 and another end of the synchronizing member 50 is rotatably connected to the other one of the two third rotating members 40.

The synchronizing member 50 is provided by some embodiments of the present disclosure, in addition to the third rotating members 40. The synchronizing member 50 is configured to cooperate with the two third rotating members 40 to realize a synchronous rotation. In some embodiments, an end of the synchronizing member 50 is rotatably connected to one of the two third rotating members 40 and another end of the synchronizing member 50 is rotatably connected to the other one of the two third rotating members 40. Therefore, when any one of the two housings 3 rotates, a corresponding one of the two third rotating members 40 may be directly or indirectly driven by the one of the two housings 3 to rotate, thereby further driving the synchronizing member 50 to rotate synchronously. In addition, when the synchronizing member 50 rotates, the synchronizing member 50 may drive the other one of the two third rotating members 40 to rotate, thereby further driving the other one of the two housings 3 to rotate. In this way, the two housings 3 may be enabled to move in opposite directions synchronously. The synchronizing member 50 may be configured to reduce the time taken to fold or unfold the rotating shaft assembly 1 and the electronic device 2. A shape, a material, and a structure of the synchronizing member 50 are not limited herein, as long as enabling the synchronizing member 50 to realize the synchronous rotation function.

In some embodiments, the synchronizing member 50 may be rotatably connected to the third rotating member 40 through a gear, a belt, and so on. The present embodiment is merely illustrated by taking the synchronizing member 50 that is rotatably connected to the third rotating member 40 through the gear as an example. That is, a plurality of teeth that are spaced apart from one another are disposed on the synchronizing member 50 and the third rotating member 40 along the rotation direction to form a gear structure.

In some embodiments, the number of the synchronizing member 50 may be an even number, for example, 2, 4, 6, and so on. The present embodiment is merely illustrated by taking the number of the synchronizing member 50 being two as an example. One synchronizing member 50 and the other synchronizing member 50 are rotatably connected to each other. The one synchronizing member 50 is rotatably connected to one of the two third rotating members 40. The other synchronizing member 50 is rotatably connected to the other one of the two third rotating members 40.

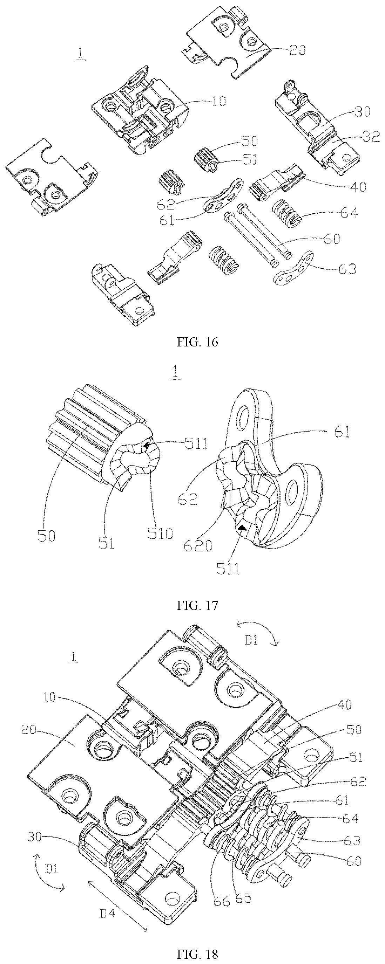

As illustrated in FIGS. 15-17, FIG. 15 is a schematic perspective structural view of a rotating shaft assembly according to still another embodiment of the present disclosure. FIG. 16 is an exploded schematic view of FIG. 15. FIG. 17 is a schematic view of a first mating portion and a second mating portion according to an embodiment of the present disclosure. In some embodiments, the synchronizing member 50 and the third rotating member 40 are disposed on a same side of the base 10. A first mating portion 51 is disposed on at least one of the synchronizing member 50 and the third rotating members 40 at a side away from the base 10. The rotating shaft assembly 1 further includes at least one first rotating shaft 60, a sliding member 61, a blocking member 63, and a first elastic member 64. The at least one first rotating shaft 60 penetrates the first mating portion 51 and the at least one of the synchronizing member 50 and the third rotating members 40 on which the first mating portion 51 is disposed. The at least one first rotating shaft 60 is connected to the base 10. The sliding member 61 is sleeved on the at least one first rotating shaft 60 and is disposed on a side of the first mating portion 51 away from the base 10. The second mating portion 62 is disposed on a side of the sliding member 61 that faces the first mating portion 51. The blocking member 63 is fixed to the at least one first rotating shaft 60 and is disposed on a side of the sliding member 61 away from the base 10. The first elastic member 64 is sleeved on the at least one first rotating shaft 60 and is disposed between the blocking member 63 and the sliding member 61.

The third rotating member 40 is configured to rotate along with the corresponding housing 3 (as illustrated by D1 in FIG. 15), thereby further driving the first mating portion 51 to rotate. The first mating portion 51 and the second mating portion 62 are configured to mate with each other to enable the sliding member 61 to slide in a direction toward or away from the third rotating member 40 (as illustrated by D4 in FIG. 15). When the sliding member 61 slides in a direction away from the third rotating member 40, the first elastic member 64 is in a compressed state that enables the second mating portion 62 to abut against the first mating portion 51 and the third rotating member 40 to be turned into a stable state after the third rotating member 40 stops rotating.

The rotating shaft may further realize a hover function based on the synchronous rotation between the third rotating members 40 and the synchronizing member 50. In some embodiments, the third rotating members 40 and the synchronizing member 50 are disposed on the same side of the base 10, which facilitates the third rotating members 40 and the synchronizing member 50 to be rotatably connected to each other. In some embodiments, the first mating portion 51 is disposed on at least one of the synchronizing member 50 and the third rotating members 40 at a side away from the base 10. In other words, the first mating portion 51 may be disposed on a side of the synchronizing member 50 away from the base 10, may be disposed on a side of the third rotating member 40 away from the base 10, or may be disposed on not only the side of the synchronizing member 50 away from the base 10 but also the side of the third rotating member 40 away from the base 10. The present embodiment is merely illustrated by taking the first mating portion 51 being disposed on a side of the synchronizing member 50 away from the base 10 as an example.

In some embodiments, the at least one first rotating shaft 60 is connected to the base 10, and other components are able to be sleeved on or fixed to the at least one first rotating shaft 60. In some embodiments, the at least one first rotating shaft 60 penetrates the other components to realize the mounting of the other components, thereby allowing a plurality of components to cooperate with one another and providing a fundamental for subsequent rotations or sliding. In some embodiments, the at least one first rotating shaft 60 may penetrate the first mating portion 51 and the at least one of the synchronizing member 50 and the third rotating members 40 on which the first mating portion 51 is disposed. That is to say, any component on which the first mating portion 51 is disposed is sleeved on the at least one first rotating shaft 60. The number of the at least one first rotating shaft 60 is equal to the number of components on which the first mating portion 51 is disposed on. As illustrated in FIG. 15, in some embodiments, since the first mating portion 51 is disposed on each of the two synchronizing members 50, the number of the at least one first rotating shaft 60 is two.

The sliding member 61 is sleeved on the at least one first rotating shaft 60 and is slidable with respect to an axis of the at least one first rotating shaft 60 (as illustrated by D4 is FIG. 15). In some embodiments, as illustrated in FIG. 15, the number of the rotating shaft is two and the sliding member 61 is sleeved on each of the rotating shaft, which limits the sliding member 61 to be slidable only with respect to the at least one first rotating shaft 60. In some embodiments, the sliding of the sliding member 61 may be realized through other means. The sliding member 61 is disposed on a side of the first mating portion 51 away from the base 10. The second mating portion 62 is disposed on parts of the sliding member 61 sleeved on the at least one first rotating shaft 60 at a side of the sliding member 61 that faces the first mating portion 51. Thus, the first mating portion 51 faces the second mating portion 62, thereby facilitating the first mating portion 51 and the second mating portion 62 to mate with one another later. The sliding member 61 and the second mating portion 62 may be implemented as a one-piece structure or separate structures. In case of the one-piece structure, the sliding member 61 and the second mating portion 62 are manufactured through the same process. The sliding member 61 and the second mating portion 62 are named differently merely for the ease of understanding. In case of the separate structures, the sliding member 61 and the second mating portion 62 are manufactured independently and further combined together through various means. A cooperation relationship between the sliding member 61 and the second mating portion 62 is not limited herein.

In some embodiments, the blocking member 63 is fixed to the at least one first rotating shaft 60 to limit the movement of other components. Various means are provided by some embodiments of the present disclosure to fix the blocking member 63 to the at least one first rotating shaft 60. In some embodiments, the blocking member 63 is fixedly connected to the at least one first rotating shaft 60, i.e., the blocking member 63 and the at least one first rotating shaft 60 are manufactured through the same process. The blocking member 63 and the at least one first rotating shaft 60 are named differently merely for the ease of understanding. In some embodiments, the blocking member 63 and the at least one first rotating shaft 60 are detachably connected to one another, i.e., the blocking member 63 cooperates with other components to be fixedly connected to the at least one first rotating shaft 60. A material of the blocking member 63 includes, but is not limited to, a plastic, a metal, and so on. The blocking member 63 is not limited herein, which may be in any shape, as long as the blocking member 63 is able to limit the position of other components. A structure of the blocking member 63 and the at least one first rotating shaft 60 is not limited herein. The present embodiment is merely illustrated by taking the blocking member 63 being sleeved on the at least one first rotating shaft 60 as an example.

The first elastic member 64 is sleeved on the at least one first rotating shaft 60 and is disposed between the sliding member 61 and the blocking member 63. The sliding member 61 is rotatably connected to the base 10 to limit a displacement of the sliding member 61, which further limits a position of an end of the first elastic member 64. In some embodiments, the first elastic member 64 may be or may be not in contact with the sliding member 61 and the blocking member 63, as long as the first elastic member 64 is ensured to be in the compressed state and is in contact with the sliding member 61 and the blocking member 63 when the sliding member 61 slides with respect to the at least one first rotating shaft 60. Furthermore, in some embodiments, the first elastic member 64 may be connected to the sliding member 61 and the blocking member 63 by means of, including but not limited to, a butt joint, a fixed connection, a detachable connection, a bond, and so on. The first elastic member 64 may be a coil spring, a volute spring, a leaf spring, a disc spring, and so on. In some embodiments, the first elastic member 64 may be any other elastic element, such as an elastic foam, a sponge, a product made of various polymer materials, and so on.

It should be noted that, the synchronizing member 50, the sliding member 61, the blocking member 63, and the first elastic member 64 may all be sleeved on the at least one first rotating shaft 60 to realize a certain state and to provide the fundamental for subsequent rotations or sliding. That is to say, a through hole may be defined on each of the synchronizing member 50, the sliding member 61, the blocking member 63, and the first elastic member 64. The at least one first rotating shaft 60 is capable of penetrating the corresponding through holes in sequence.

As mentioned above, the first mating portion 51 may rotate along with the third rotating member 40. In case of the first mating portion 51 being disposed on the third rotating member 40, the first mating portion 51 is directly driven by the third rotating member 40 to rotate. In case of the first mating portion 51 being disposed on the synchronizing member 50, after the synchronizing member 50 is driven by the third rotating member 40 to rotate, the first mating portion 51 is further driven by the synchronizing member 50 to rotate. The first mating portion 51 and the second mating portion 62 may mate with each other to enable the rotation of the first mating portion 51 to drive the second mating portion 62 to slide. In some embodiments, the synchronizing member 50 and the third rotating member 40 are disposed on the same side of the base 10 and the base 10 is unable to move as being fixed to other components. In this way, the third rotating member 40 and the synchronizing member 50 remain still and only the sliding member 61 slides in a direction toward or away from the third rotating member 40.

When the sliding member 61 slides in a direction away from the third rotating member 40, since the blocking member 63 is disposed on a side of the first elastic member 64 away from the third rotating member 40, the first elastic member 64 is limited to move within a certain range, which enables the first elastic member 64 to be in contact with the sliding member 61 and the blocking member 63 and to be compressed by the sliding member 61 to be turned into the compressed state. It should be noted that, with regard to the compression of the first elastic member 64, before the third rotating member 40 starts to rotate, i.e., the first elastic member 64 being in an initial state, the first elastic member 64 may be in a compressed state, a balanced state, or a stretched state. The initial state of the first elastic member 64 is not limited herein, as long as enabling the first elastic member 64 to be turned into the compressed state when the sliding member 61 moves backward.

In some embodiments, the first elastic member 64 may be disposed in a pre-compression state between the sliding member 61 and the blocking member 63. The pre-compression state refers to the initial state of the first elastic member 64 being already the compressed state before the third rotating member 40 starts to rotate. That is to say, when the first mating portion 51 and the second mating portion 62 do not mate with one another, i.e., when the sliding member 61 does not move in a direction toward or away from the third rotating member 40, the first elastic member 64 is already in the compressed state. The pre-compression state of the first elastic member 64 may compensate an axial movement of the first elastic member 64 with respect to the at least one first rotating shaft 60. In this way, after the rotating shaft assembly 1 is used for a while, given that a size of the first elastic member 64 may be changed or a structure of the first elastic member 64 may become loose, the first elastic member 64 that has the pre-compression state may compensate the axial movement with respect to the at least one first rotating shaft 60, thereby improving the stability of the rotating shaft assembly 1, ensuring a long-term consistency in a torque of the rotating shaft assembly 1, and improving a balance of the torque.

When the first elastic member 64 is in the compressed state, the first elastic member 64 may apply a bouncing force to the sliding member 61, which enables the second mating portion 62 to closely abut against the first mating portion 51. The bouncing force may further be turned into a certain pressure applied on the first mating portion 51 by the second mating portion 62. A friction and a pressure between the second mating portion 62 and the first mating portion 51 are positively correlated with one another, i.e. the greater the pressure, the greater the friction. When the friction is greater than a predetermined value and the third rotating member 40 stops rotating, the third rotating member 40 may not rotate with respect to the rotating shaft. Thus, the sliding member 61 and the third rotating member 40 remain still, i.e., the third rotating member 40 is in a stable state. The stable state of the third rotating member 40 refers to a state where, when the third rotating member 40 stops rotating, the third rotating member 40 may not further be rotated backward with respect to the sliding member 61 by a self-gravity, an external force, or etc. and fall. That is to say, due to the bounding force of the first elastic member 64, the sliding member 61 applies an additional pressure to the third rotating member 40, which allows a friction between the third rotating member 40 and the sliding member 61 to be greater than the predetermined value. In this way, the sliding member 61 may not rotate with respect to the third rotating member 40 and fix the third rotating member 40, which enables the third rotating member 40 to realize a hover function, a self-tightening function, and so on. The predetermined value may be a gravity of the third rotating member 40 or an external force applied on the third rotating member 40, such as the bounding force generated when the flexible screen 4 is bent, a weight of the electronic device 2, and so on.

In addition, in order to enable the third rotating member 40 to continue rotating, a force that is greater than a predetermined force needs to be applied on third rotating member 40 to transition the third rotating member 40 from being still with respect to the sliding member 61 to sliding with respect to the sliding member 61. A part of the force is configured to compensate the friction generated through the above process. A remaining part of the force is configured to drive the third rotating member 40 to continue rotating. After the force is applied on the third rotating member 40, the third rotating member 40 is driven by the force to continue rotating and the sliding member 61 transitions from sliding in a direction away from the third rotating member 40 to sliding in a direction toward the third rotating member 40. When the sliding member 61 slides in the direction toward the two third rotating members 40 and the first elastic member 64 is in the compressed state, the first elastic member 64 restores from deformation so that the bouncing force of the first elastic member 64 reduces. In this case, less pressure is applied by the first elastic member 64, the friction applied on the third rotating member 40 by the sliding member 61 reduces, and thus less force is required to drive the third rotating member 40 to continue rotating. Therefore, the third rotating member 40 may rotate more easily and, due to the bounding force of the first elastic member 64, the sliding member 61 slides in the direction toward the third rotating member 40 more quickly to prepare for a next hover of the rotating shaft assembly 1.

It should be noted that, the torque of the rotating shaft assembly 1 is relevant to the friction. When the third rotating member 40 rotates, the friction varies as the sliding member 61 slides with respect to the at least one first rotating shaft 60. That is to say, the torque of the rotating shaft assembly 1 may become greater or smaller as a result of a state of the first elastic member 64 being changed by the sliding member 61.

In summary, compared to the related art that provides a structure with only a cam to realize the hover function, some embodiments of the present disclosure provide the first mating portion 51, the second mating portion 62, and the first elastic member 64 that cooperate or mate with one another to provide a greater friction to improve a friction performance, thereby realizing the hover function, self-tightening function, and so on. That is, given the same magnitude of friction required, each of the first mating portion 51, the second mating portion 62, and the first elastic member 64 provided by some embodiments of the present disclosure may have a reduced size, which further allows sizes of other components to be reduced correspondingly. In this way, the overall size of the rotating shaft assembly 1 may be reduced, thereby realizing a more compact structure of the rotating shaft assembly 1 and saving space for other components.

As further illustrated in FIG. 17, in some embodiments, the first mating portion 51 includes a plurality of first bulges 510 that are spaced apart from one another The second mating portion 62 includes a plurality of second bulges 620 that are spaced apart from one another. A plurality of peaks 511 are defined on the plurality of first bulges 510 and the plurality of second bulges 620. When the sliding member 61 slides in a direction away from the third rotating member 40 and the plurality of peaks 511 on the plurality of first bulges 510 are in contact with the plurality of peaks 511 on the plurality of second bulges 621, the first elastic member 64 is in the compressed state that enables the second mating portion 62 to abut against the first mating portion 51.

The first mating portion 51 includes the plurality of first bulges 510. The second mating portion 62 includes the plurality of second bulges 620. The plurality of peaks 511 are defined on the plurality of first bulges 510 and the plurality of second bulges 620. In addition to the plurality of peaks 511, a plurality of valleys and a plurality of slopes are further defined on the plurality of first bulges 510 and the plurality of second bulges 620. Each of a plurality of peaks 511 refers to a highest point or a point at the highest level of a corresponding one of the plurality of first bulges 510 or a highest point or a point at the highest level of a corresponding one of the plurality of second bulges 620. Each of the plurality of valleys refers to a lowest point or a point at the lowest level of a corresponding one of the plurality of first bulges 510 or a lowest point or a point at the lowest level of a corresponding one of the plurality of second bulges 620. Each of the plurality of slopes refers to a side between each of the plurality of peaks 511 and a corresponding one of the plurality of valleys.

When the sliding member 61 slides in a direction away from the third rotating member 40 and the plurality of peaks 511 on the plurality of first bulges 510 are in contact with the plurality of peaks 511 on the plurality of second bulges 620, the first elastic member 64 is in the compressed state that enables the sliding member 61 to abut against the two third rotating members 40. When the third rotating member 40 stops rotating, the third rotating member 40 is in the stable state. The plurality of first bulges 510 and the plurality of second bulges 621 are not limited herein, which may be components in any shape, as long as the plurality of first bulges 510 and the plurality of second bulges 621 are able to cooperate with one another.

When the third rotating member 40 does not rotate with respect to the sliding member 61, the plurality of peaks 511 on the plurality of first bulges 510 are in contact with the plurality of valleys on the plurality of second bulges 621 and the plurality of peaks 511 on the plurality of second bulges 620 are in contact with the plurality of valleys on the plurality of first bulges 510. When the third rotating member 40 slides with respect to the sliding member 61, the plurality of peaks 511 on the plurality of first bulges 510 slide along the plurality of slopes on the plurality of second bulges 620 and the plurality of peaks 511 on the plurality of second bulges 620 slide along the plurality of slopes on the plurality of first bulges 510, until the plurality of peaks 511 on the plurality of first bulges 510 are in contact with the plurality of peaks 511 on the plurality of second bulges 621. In this case, the third rotating member 40 is farthest from the sliding member 61. That is, the first elastic member 64 is compressed to the greatest extent and provides the greatest bouncing force, which further improves the friction performance, the hover performance, and the self-tightening performance of the rotating shaft assembly 1. When the third rotating member 40 is driven by the external force to continue sliding with respect to the sliding member 61, the plurality of peaks 511 on the plurality of first bulges 510 continue sliding along the plurality of slopes on the plurality of second bulges 620 and the plurality of peaks 511 on the plurality of second bulges 620 continue sliding along the plurality of slopes on the plurality of first bulges 510, until the plurality of peaks 511 on the plurality of first bulges 510 are in contact with the plurality of valleys on the plurality of second bulges 621 and the plurality of peaks 511 on the plurality of second bulges 620 are in contact with the plurality of valleys on the plurality of first bulges 510. In this case, a distance between the third rotating member 40 and the sliding member 61 reduces continuously. That is, the first elastic member 64 is compressed to a less extent and provides a smaller bouncing force. Since the friction reduces, the third rotating member 40 rotates more easily. The plurality of first bulges 510 and the plurality of second bulges 620 may continue repeating the above movement and preparing for the next hover of the rotating shaft assembly 1.

In addition, since the hover of the rotating shaft assembly 1 may be realized when the plurality of peaks 511 on the plurality of first bulges 510 are in contact with the plurality of peaks 511 on the plurality of second bulges 621, a hover angle may be determined by the number, the position, and the size of the plurality of first bulges 510 and the plurality of second bulges 620. In some embodiments, when the number of the plurality of first bulges 510 on the first mating portion 51 is six and the plurality of peaks 511 on the plurality of first bulges 510 are evenly spaced apart from each other, the hover of the rotating shaft assembly 1 may be realized every time the third rotating member 40 rotates by 60 degrees with respect to the sliding member 61.

As illustrated in FIG. 18, FIG. 18 is a schematic perspective structural view of a rotating shaft assembly according to still another embodiment of the present disclosure. In some embodiments, the rotating shaft assembly 1 further includes a second rotating shaft 65 and a second elastic member 66. The second rotating shaft 65 penetrates at least one of the synchronizing member 50 and the third rotating member 40 that is not or free of being penetrated by the at least one first rotating shaft 60, i.e., the second rotating shaft 65 penetrates at least one selected from the rest of the synchronizing member 50 and the third rotating member 40 that is not penetrated by the at least one first rotating shaft 60. The second rotating shaft 65 is further connected to the base 10. The sliding member 61 is sleeved on the second rotating shaft 65. The blocking member 63 is fixed to the second rotating shaft 65. The second elastic member 66 is sleeved on the second rotating shaft 65 and is disposed between the blocking member 63 and the sliding member 61. When the sliding member 61 slides in a direction away from the third rotating member 40, the second elastic member 66 is in a compressed state that enables the second mating portion 62 to abut against the first mating portion 51.

The rotating shaft assembly 1 includes the second rotating shaft 65 and the second elastic member 66, in addition to the at least one first rotating shaft 60 and the first elastic member 64. In some embodiments, the second rotating shaft 65 is connected to the base 10 and is configured to allow other components to be sleeved on or fixed to the second rotating shaft 65. In some embodiments, the second rotating shaft 65 penetrates other components to realize the mounting of the other components, which allows a plurality of components to cooperate with one another. The second rotating shaft 65 penetrates at least one of the synchronizing member 50 and the third rotating members 40 that is not penetrated by the at least one first rotating shaft 60. That is to say, when the first mating portion 51 is not disposed on each of the synchronizing member 50 and the third rotating members 40, the at least one first rotating shaft 60 penetrates the component, which is selected from the synchronizing member 50 and the third rotating members 40, on which the first mating portion 51 is disposed and the second rotating shaft 65 penetrates the rest component, which is selected from the synchronizing member 50 and the third rotating members 40, on which the first mating portion 51 is not disposed. As illustrated in FIG. 18, in some embodiments, the first mating portion 51 is disposed on each of two synchronizing members 50, the first rotating shaft 60 penetrates the two synchronizing members 50, and the second rotating shaft 65 penetrates the two third rotating members 40.

In addition, the sliding member 61 is sleeved on the second rotating shaft 65 and the blocking member 63 is fixed to the second rotating shaft 65. Therefore, the second elastic member 66 is sleeved on the second rotating shaft 65 and is disposed between the blocking member 63 and the sliding member 61, thereby further realizing the mounting of the second elastic member 66.

As mentioned above, when the third rotating member 40 rotates, the sliding member 61 is driven by the third rotating member 40 to rotate in the direction away from the third rotating member 40, which enables the first elastic member 64 to be turned to the compressed state. Since the sliding member 61 is further sleeved on the second rotating shaft 65, when the sliding member 61 slides in a direction away from the third rotating member 40, the sliding member 61 further abuts against and compresses the second elastic member 66, which enables the second elastic member 66 to be compressed along with the first elastic member 64. It should be noted that, the compression of the second elastic member 66 and the compression of the first elastic member 64 share the same purpose, i.e., both provide the bouncing force to enable the second mating portion 62 to closely abut against the first mating portion 51. In this way, the second mating portion 62 applies a certain positive pressure on the first mating portion 51, which increases the friction between the sliding member 61 and the third rotating member 40, thereby further improving the hover performance and, in other words, further reducing the size of the rotating shaft assembly 1.

In some embodiments, the second elastic member 66 may have the pre-compression state. The pre-compression state is described above in detail, which will not be repeated herein.

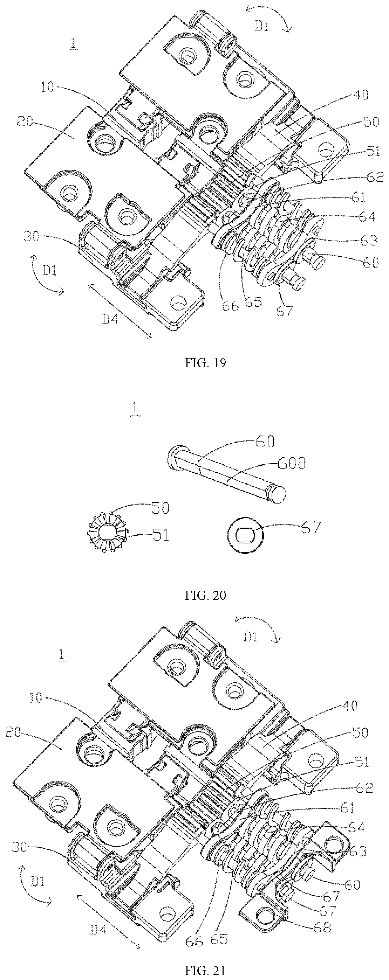

As illustrated in FIG. 19 and FIG. 20, FIG. 19 is a schematic perspective structural view of a rotating shaft assembly according to still another embodiment of the present disclosure. FIG. 20 is an exploded schematic view of a first rotating shaft, a first mating portion, and a friction member according to an embodiment of the present disclosure. In some embodiments, the rotating shaft assembly 1 further includes a friction member 67. The friction member 67 is disposed on a side of the blocking member 63 away from the base 10. A flat structure 600 is arranged on at least a part of an outer peripheral side of the at least one first rotating shaft 60. The friction member 67 and the at least one of the synchronizing member 50 and the third rotating members 40 on which the first mating portion 51 is disposed are sleeved on the flat structure 600, which enables, when the first mating portion 51 rotates, the at least one first rotating shaft 60 and the friction member 67 to be driven by the first mating portion 51 to rotate.

In some embodiments, the friction member 67 is configured to provide a friction. A material of the friction member 67 includes, but not is limited to, a plastic, a metal, and any other material with a high coefficient of friction. The friction member 67 is not limited herein, which may be a component in any shape, as long as the friction member 67 is able to provide the friction of the elastic member. The friction member 67 is sleeved on the at least one first rotating shaft 60, i.e., a through hole is defined on the friction member 67 and the at least one first rotating shaft 60 penetrates the through hole 810.

With regard to the flat structure 600 mentioned above, when a periphery of the at least one first rotating shaft 60 is in shape of a circle, any component sleeved on the at least one first rotating shaft 60 may be difficult to be fixed to the at least one first rotating shaft 60. In this way, the periphery of the at least one first rotating shaft 60 needs to be changed from a circle to another shape through various methods, e.g., milling, thereby ensuring the rotating members to be fixed or clamped when the rotating members rotate. Therefore, the flat structure 600 may refer to a structure that has a non-circular peripheral shape. In some embodiments, a periphery of the flat structure 600 may be in shape of a square, a rectangle, an ellipse, and so on. In some embodiments, the flat structure 600 is formed through defining a limit recess or groove on the at least one first rotating shaft 60 that has a cylindrical shape, which changes at least part of the at least one first rotating shaft 60 from the cylindrical shape to an elliptical shape or a rectangular-like shape. The flat structure 600 is configured to limit the circumferential movement of other components sleeved thereon, which ensures the other components sleeved on the at least one first rotating shaft 60 to remain still with respect to the at least one first rotating shaft 60. That is, when the at least one first rotating shaft 60 rotates, the other components sleeved on the at least one first rotating shaft 60 are driven by the at least one first rotating shaft 60 to rotate. The flat structure 600 is not limited herein, which may be a component in any shape, as long as the flat structure 600 is able to limit a radial movement of the other components sleeved thereon. It should be noted that, in an actual production, the at least one first rotating shaft 60 and the flat structure 600 may be implemented as a one-piece structure. The at least one first rotating shaft 60 and the flat structure 600 herein are named differently merely for the ease of understanding.

In the present embodiment, the friction member 67, the at least one of the synchronizing member 50 and the third rotating members 40 on which the first mating portion 51 is disposed are sleeved on the flat structure 600 of the at least one first rotating shaft 60. That is to say, the through hole 810 defined on each of the friction member 67 and the at least one of the synchronizing member 50 and the third rotating members 40 on which the first mating portion 51 is disposed shares the same shape as the flat structure 600. In this way, the friction member 67 and the at least one of the synchronizing member 50 and the third rotating members 40 on which the first mating portion 51 is disposed are ensured to be fixed to the at least one first rotating shaft 60. That is, when at least one of the synchronizing member 50 and the third rotating members 40 on which the first mating portion 51 is disposed rotates, the at least one first rotating shaft 60 is driven by the at least one of the synchronizing member 50 and the third rotating members 40 on which the first mating portion 51 is disposed to rotate, which further drives the friction member 67 to rotate. It should be noted that, since a through hole defined on the sliding member 61 is in shape of a circle, which is not consistent with the shape of the flat structure 600, a gap is defined between the sliding member 61 and the flat structure 600. In this way, the sliding member 61 may be rotatable with respect to the at least one first rotating shaft 60.

Since the friction member 67 is disposed on the side of the blocking member 63 away from the base 10, when the friction member 67 rotates synchronously along with the at least one first rotating shaft 60, the friction member 67 frictionally engages with the blocking member 63, thereby generating a circumferential friction. When one end of the first elastic member 64 applies the bouncing force on the sliding member 61, another end of the first elastic member 64 further applies the bouncing force on the blocking member 63, which enables the blocking member 63 to apply a pressure on the friction member 67. When the first elastic member 64 continues being compressed, the pressure applied on the first elastic member 64 keeps becoming greater, thereby further increasing the circumferential friction, improving the hover performance and the self-tightening performance of the rotating shaft assembly 1, reducing the size of the rotating shaft assembly 1, and realizing a more compact structure of the rotating shaft assembly 1.

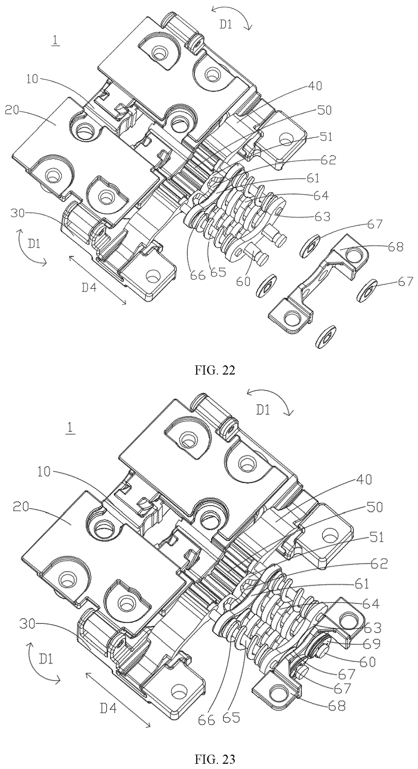

As further illustrated in FIG. 21 and FIG. 22, FIG. 21 is a schematic perspective structural view of a rotating shaft assembly according to still another embodiment of the present disclosure. FIG. 22 is a partial exploded schematic view of FIG. 21. In some embodiments, rotating shaft assembly 1 further includes the mounting member 68. The mounting member 68 is fixed to the at least one first rotating shaft 60 and is disposed on a side of the blocking member 63 away from the base 10. In some embodiments, the rotating shaft assembly 1 includes two friction members 67. One friction member 67 is disposed between the blocking member 63 and the mounting member 68. The other friction member 67 is disposed on a side of the mounting member 68 away from the blocking member 63.

In some embodiments, the mounting member 68 is fixed to the at least one first rotating shaft 60 and is configured to enable the rotating shaft assembly 1 to be connected to or mounted to other components. A material of the mounting member 68 includes, but is not limited to, a plastic, a metal, and so on. The mounting member 68 is not limited herein, which may be a component in any shape, as long as the mounting member 68 enables the rotating shaft assembly 1 to be connected to other components. In some embodiments, a mounting hole may be defined on the mounting member 68. Another component, e.g., an installing or decorating member, may be connected to the rotating shaft assembly 1 through the mounting hole and a corresponding screw. In addition, when the mounting member 68 is mounted to the another component, the mounting member 68 remains still, i.e., the mounting member 68 is not slidable or rotatable with respect to the at least one first rotating shaft 60.

Since the two friction members 67 are disposed on opposite sides of the mounting member 68 respectively, when one end of the first elastic member 64 is compressed, another end of the first elastic member 64 may apply the bounding force on the two friction members 67, which further increases the friction, thereby further reducing the size of the rotating shaft assembly 1 and realizing a more compact structure of the rotating shaft assembly 1. Besides, the mounting member 68 further enables the blocking member 63 to be fixed to the at least one first rotating shaft 60 and to limit the first elastic member 64.

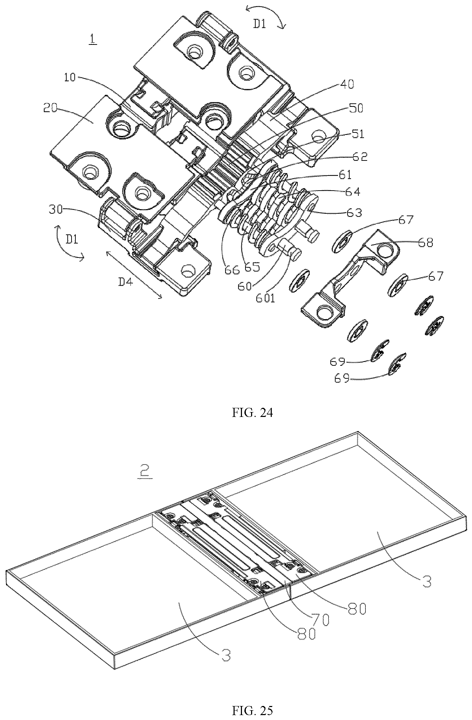

As further illustrated in FIG. 23 and FIG. 24, FIG. 23 is a schematic perspective structural view of a rotating shaft assembly according to still another embodiment of the present disclosure. FIG. 24 is a partial exploded schematic view of FIG. 23. In some embodiments, a snap slot 601 is defined on a periphery of an end of the at least one first rotating shaft 60 at a side of the blocking member 63 away from the base 10. The rotating shaft assembly 1 further includes a snap member 69. A part of the snap member 69 is disposed in the snap slot 601.

In some embodiments, the snap member 69 is configured to limit the movement of other components. The snap member 69 is sleeved on the at least one first rotating shaft 60. That is, a through hole is defined on the snap member 69 and the at least one first rotating shaft 60 penetrates the through hole. A material of the snap member 69 includes, but is not limited to, a plastic, a metal, and so on. The snap member 69 is not limited herein, which may be a component in any shape, as long as the snap member 69 is able to limit the movement of other components. In some embodiments, the snap member 69 may be a circlip.

In some embodiments, the snap member 69 is disposed in the snap slot 601 and is located at a side of the friction member 67 away from the blocking member 63. That is, the snap member 69 is configured to further avoid the friction member 67 that is disposed at a side of the mounting member 68 away from the base 10 from falling, thereby further improving the stability of the rotating shaft assembly 1.

As further illustrated in FIG. 4 and FIG. 5, some embodiments of the present disclosure provide the electronic device 2. The electronic device 2 includes the flexible screen 4, the two housings 3, and the rotating shaft assembly 1 mentioned above. At least a part of one of the two housings 3 and at least a part of the other one of the two housings 3 are disposed on opposite sides of the rotating shaft assembly 1. The housing 3 is rotatably connected to the corresponding rotating member 20 of the rotating shaft assembly 1. The flexible screen 4 is disposed on the same side of the two first rotating members 20 and the rotating shaft assembly 1.

The electronic device 2 provided by some embodiments of the present disclosure includes, but is not limited to, a mobile terminal with the flexible screen 4, such as a cell phone, a tablet computer, a laptop, a palmtop, a personal computer (PC), a personal digital assistant (PDA), a portable media player (PMP), a navigation device, a wearable device, a smart bracelet, a pedometer, etc., and a fixed terminal, such as a digital TV, a desktop computer, and etc. A type of the electronic device 2 is not limited herein. The rotating shaft assembly 1 according to the above-mentioned embodiments may simplify the structure of the rotating shaft assembly 1 and the electronic device 2, saving the cost of the electronic device 2, reducing the number of components required, and enabling the electronic device 2 to provide the waterdrop shaped screen in the folded state.

In some embodiments, the number of the rotating shaft assembly 1 is two. That is, one rotating shaft assembly 1 and the other rotating shaft assembly 1 are disposed symmetrically on opposite sides of the electronic device 2. Since each rotating shaft assembly 1 is fixed to the two housings 3, each rotating shaft assembly 1 is ensured to have a substantially identical rotation angle during the rotation, thereby realizing the synchronous rotation.

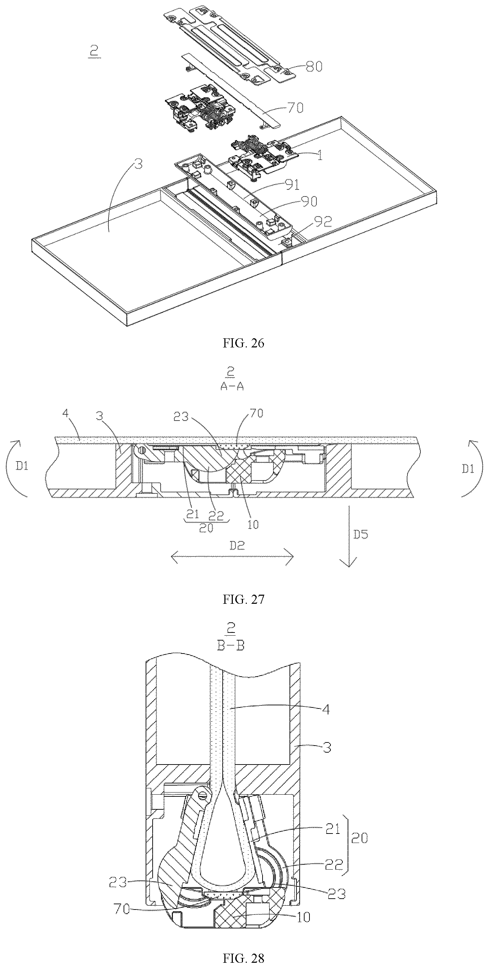

As further illustrated in FIG. 1 and FIGS. 25-28, FIG. 25 is a schematic perspective structural view of an electronic device after removing a flexible screen according to an embodiment of the present disclosure. FIG. 26 is an exploded schematic view of FIG. 25. FIG. 27 is a partial cross-sectional view of FIG. 4 along an A-A direction according to another embodiment of the present disclosure. FIG. 28 is a partial cross-sectional view of FIG. 8 along a B-B direction according to another embodiment of the present disclosure. In some embodiments, the electronic device 2 further includes a first support 80 disposed between the two first rotating members 20. The first support 80 is configured to abut against the flexible screen 4. The electronic device 2 has an unfolded state where an extending direction of each of the two first rotating members 20 is substantially parallel to an arrangement direction of the two first rotating members 20. When the electronic device 2 is in the unfolded state, a raised portion 23 is disposed on a side of each of the two first rotating members 20 that faces the other one of the two first rotating members 20 and the first support 80 abuts against the raised portion 23. When the raised portion 23 rotates, the first support 80 may be driven by the raised portion 23 to move in a direction toward the base 10. After the first support 80 abuts against the base 10, the first support 80 and the raised portion 23 are spaced apart from one another.

The first support 80 is configured to abut against the flexible screen 4, which improves a mechanical strength of the flexible screen 4 and further controls a shape of the waterdrop shaped screen when the electronic device 2 moves. A material, a shape, and a structure of the first support 80 are not limited herein, as long as enabling the first support 80 to abut against the flexible screen 4. In addition, since the first support 80 is disposed between the connecting portions 22 of the two first rotating members 20, the overall thickness of the electronic device 2 may be reduced. Besides, due to the concise structure of the rotating shaft assembly 1, the structure of the first support 80 may be correspondingly simplified.

When the electronic device 2 is in the unfolded state, the raised portion 23 is disposed on a side of each of the two first rotating members 20 that faces the other one of the two first rotating members 20. The raised portion 23 may refer to a part of the connecting portion 22. As mentioned above, the connecting portion 22 is configured to be rotatably connected to the base 10. That is, the raised portion 23 may be a part of the connecting portion 22 of each of the two first rotating members 20 that faces the other one of the two first rotating members 20 and protrudes the mounting portion 21. In some embodiments, the raised portion 23 and the first rotating member 20 may be implemented as a one-piece structure. That is, the raised portion 23 and the first rotating member 20 are manufactured through the same process. The raised portion 23 and the first rotating member 20 are named differently merely for the ease of understanding.

The raised portions 23 of the two first rotating members 20 protrude toward the center of the rotating shaft assembly 1. In this way, the raised portion is configured to abut against the first support 80, which ensures the stability of the first support 80 and allows the flexible screen 4 to be disposed stably on the first support 80. In case of the electronic device 2 being transitioning from the unfolded state to the folded state, when the housing 3 rotates, the corresponding first rotating member 20 is driven by the housing 3 to rotate with respect to the base 10, thereby further allowing the corresponding raised portion 23 to rotate correspondingly. Since the raised portion 23 is located at the center of the rotating shaft assembly 1, when the two housings 3 rotate closer to each other, the raised portion 23 may rotate in a direction away from the flexible screen 4, i.e., rotate downward. In this way, when the raised portion 23 rotates downward, the first support 80 moves in a direction toward the base 10 due to a self-gravity or a cooperation of other components. After the raised portion 23 rotates by a certain angle, the first support 80 abuts against the base 10 and thus the position of the first support 80 is fixed. When the raised portion 23 continues rotating, the raised portion 23 is separated from the first support 80 so that the position of the first support 80 is no longer affected by the rotation of the raised portion 23.

In terms of the flexible screen 4, when the electronic device 2 transitions from the unfolded state to the folded state, the housing 3 and the corresponding first rotating member 30 rotate and compress the flexible screen 4, which results in a lower side of the flexible screen 4 protruding downward, i.e., protruding in a direction toward the base 10. When the first support 80 abuts against the base 10, since the flexible screen 4 abuts against the first support 80, the first support 80 is able to control a position of the lower end of the flexible screen 4. Therefore, the position of the lower end of the flexible screen 4 may be controlled by a position where the first support 80 abuts against the base 10, thereby further controlling the shape of the waterdrop shaped screen.

After the waterdrop shaped screen is formed, two kinds of bending areas are defined, i.e., an outward bending area and an inward bending area. The outward bending area is defined between the housing 3 and the corresponding first rotating member 20. The inward bending area is defined between the first rotating member 20 and the first support 80. A tensile stress is applied to the flexible screen 4 located in the outward bending area. A compressive stress is applied on the flexible screen 4 located in the inward bending area. Therefore, in some embodiments of the present disclosure, the shape of the waterdrop shaped screen and the magnitude of the force applied on the waterdrop shaped screen may be determined by the position of each of the housing 3, the first rotating member 20, and the first support 80 when the electronic device 2 is in the folded state.

In some embodiments, a limit recess or groove is defined on a side of the base 10 that faces the first support 80. When the first support 80 moves in a direction toward the base 10, at least a part of the first support 80 may be received in the limit recess or groove and may abut against a sidewall of the limit recess or groove. Therefore, a position where the first support 80 abuts against the base 10 may be adjusted through defining the limit recess or groove on the base 10, thereby further adjusting the shape of the waterdrop shaped screen and the magnitude of the force applied on the waterdrop shaped screen.

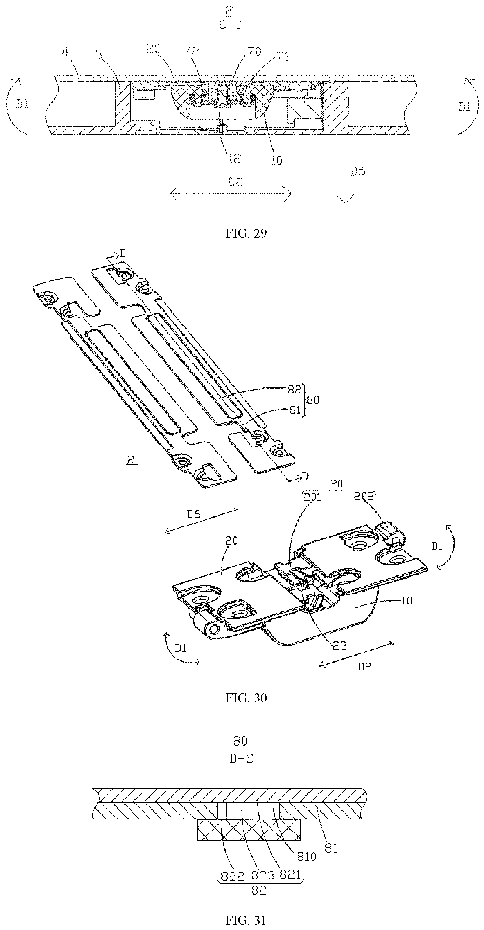

As further illustrated in FIG. 29, FIG. 29 is a partial cross-sectional view of FIG. 4 along a C-C direction according to an embodiment of the present disclosure. In the present embodiment, the electronic device 2 further includes a bracket 71 that is disposed on a side of the first support 80 away from the flexible screen 4 and is connected to the first support 80. In addition, the electronic device 2 further includes a third elastic member 72 that is disposed between the bracket 71 and the base 10. When the raised portion 23 rotates, the third elastic member 72 is in a deformation state that enables the third elastic member 72 to drive the first support 80 to move along a direction toward the base 10 through a bouncing force.

In addition to the first support 80, the electronic device 2 further includes the bracket 71 and the third elastic member 72. The bracket 71 is configured to mount the third elastic member 72. The bracket 71 may be disposed on a side of the first support 80 away from the flexible screen 4. That is, the bracket 71 may be disposed below the first support 80. A positional relationship between the bracket 71 and the base 10 will be further illustrated herein later. The bracket 71 may be further connected to the first support 80 and the third elastic member 72 is disposed between the bracket 71 and the base 10. The third elastic member 72 may be a coil spring, a volute spring, a leaf spring, a disc spring, and so on. In some embodiments, the third elastic member 72 may be any other elastic element, such as an elastic foam, a sponge, a product made of various polymer materials, and so on. In some embodiments, the bracket 71 and the first support 80 may be fixedly or detachably connected to each other. When the bracket 71 and the first support 80 are detachably connected to each other, the bracket 71 and the first support 80 may be connected through a screw connection, a snap connection, and so on.

As mentioned above, when the first rotating member 20 rotates, the corresponding raised portion 23 rotates in a direction away from the flexible screen 4, i.e., rotate downward. When the raised portion 23 rotates, the third elastic member 72 is in the deformation state. The deformation state may refer to the third elastic member 72 being in a compressed state or a stretched state. The third elastic member 72 in the deformation state may apply a bouncing force on the bracket 71 and further to the first support 80. In this way, the first support 80 is driven by the bouncing force to move in a direction toward the base 10. That is, the first support 80 moves downward closely against the raised portion 23 until the first support 80 abuts against the base 10. Therefore, the bouncing force applied by the third elastic member 72 on the bracket 71 enables the first support 80 to abut against the base 10, thereby improving the stability of the first support 80 during the movement.

In some embodiments, the third elastic member 72 is disposed between the bracket 71 and the first support 80. When the raised portion 23 rotates, the third elastic member 72 is in the compressed state. That is, when the raised portion 23 rotates, the third elastic member 72 pushes the bracket 71 to move downward and further drives the first support 80 to move downward. In some embodiments, the third elastic member 72 is disposed on a side of the bracket 71 away from the first support 80. In this case, when the raised portion 23 rotates, the third elastic member 72 is in the stretched state. That is, when the raised portion 23 rotates, the third elastic member 72 drags the bracket 71 to move downward and further drives the first support 80 to move downward. The present embodiment is merely illustrated by taking the third elastic member 72 being disposed between the bracket 71 and the first support 80 as an example.

As further illustrated in FIG. 29, in some embodiments, a receiving space 12 is defined on a side of the base 10 away from the rotating space 11. The third elastic member 72 and at least a part of the bracket 71 are disposed in the receiving space 12. The third elastic member 72 is disposed on an inner sidewall of the receiving space 12.

In some embodiments, the receiving space 12 is defined on a side of the base 10 away from the rotating space 11. That is, the receiving space 12 is defined on a lower side of the base 10. In other words, the receiving space 12 is defined on a side of the base 10 away from the flexible screen 4. The third elastic member 72 and at least a part of the bracket 71 are disposed in the receiving space 12. The third elastic member 72 is disposed on the inner sidewall of the receiving space 12. In this way, the overall thickness of the electronic device 2 may be reduced, which allows the overall structure of the electronic device 2 to be more compact. The present embodiment is illustrated by taking the third elastic member 72 and the entire bracket 71 being disposed in the receiving space 12 as an example.

In some embodiments, the third elastic member 72 is disposed in a pre-deformation state between the base 10 and the bracket 71. When the first support 80 abuts against the base 10, the third elastic member 72 remains in the deformation state.

The pre-deformation state of the third elastic member 72 refers to an initial state of the third elastic member 72 before the raised portion 23 starts to rotate. When the raised portion 23 does not rotate, since the third elastic member 72 is already in the deformation state, the first support 80 is enabled to closely abut against the raised portion 23, which improves the stability of the first support 80. When the first support 80 is moving in a direction toward the base 10, the third elastic member 72 gradually restores from the deformation. In the present embodiment, the third elastic member 72 remains in the deformation state even if the first support 80 abuts against the base 10, which ensures that the first support 80 closely abuts against the base 10, thereby further improving the stability of the first support 80.

As further illustrated in FIG. 26 and FIG. 30, FIG. 30 is an exploded schematic view of a second support and a rotating shaft assembly according to an embodiment of the present disclosure. In the present embodiment, the electronic device 2 further includes a second support 80 that is fixed to the first rotating member 20. The second support 80 includes a supporting portion 81 and a sliding portion 82 slidably connected to the supporting portion 81. The supporting portion 81 is connected to the first rotating member 20. The sliding portion 82 is configured to be connected to the flexible screen 4. The electronic device 2 has an unfolded state where an extending direction of each of the two first rotating members 20 being substantially parallel to an arrangement direction of the two first rotating members 20. When the electronic device 2 is in the unfolded state, a sliding direction of the sliding portion 82 is substantially parallel to the arrangement direction of the two first rotating members 20.

In addition to the first support 80, the electronic device 2 further includes the second support 80. The second support 80 is connected to the first rotating member 20. In this way, an angle rotated by the first rotating member 20 is substantially equal to an angle rotated by the second support 80. The second support 80 may be fixed to the first rotating member 20 through a fixed connection, a detachable connection, and any other means of connection. In case of the fixed connection, the second support 80 and the two first rotating members 20 may be implemented as a one-piece structure. That is, the second support 80 and the first rotating member 20 are manufactured through the same process. The second support 80 and the first rotating member 20 are named differently merely for the ease of understanding. In case of the detachable connection, the second support 80 and the first rotating member 20 are connected to each other through a screw, a snap, and so on.

The first support 80 and the second support 80 share the same purpose, i.e., both are configured to support the flexible screen 4. However, a difference between the first support 80 and the second support 80 is that, the flexible screen 4 abuts against the first support 80 while the flexible screen 4 is connected to the second support 80. The second support 80 includes the supporting portion 81 and the sliding portion 82 slidably connected to the supporting portion 81. The supporting portion 81 is connected to the first rotating member 20. The sliding portion 82 is configured to be connected to the flexible screen 4. That is, the sliding portion 82 is slidable on the supporting portion 81. In other words, the flexible screen 4 is slidable on the supporting portion 81. When the electronic device 2 is in the unfolded state, a sliding direction of the flexible screen 4 or the sliding portion 82 is substantially parallel to the arrangement direction of the two first rotating members 20. In some embodiments, the flexible screen 4 may be adhered to the sliding portion 82 and the housing 3 through a backing adhesive.

Since the flexible screen 4 has a multiple layer structure where a material and a structure of each layer are different, an internal stress is generated when the flexible screen 4 rotates. In this way, when the flexible screen 4 generates the internal stress, given the flexible screen 4 being connected to the sliding portion 82, the sliding portion 82 connected to the flexible screen 4 is driven by the internal stress to slide, which reduces the stress generated due to the deformation of the flexible screen 4 and further reduces the crease formed by the stress, thereby cushioning the flexible screen 4, avoiding the damage to the flexible screen 4, and improving the service life of the flexible screen 4. In addition, a shape, a structure, a material, and etc. of the supporting portion 81 and the sliding portion 82 are not limited herein, as long as the supporting portion 81 is enabled to realize the supporting function and the sliding portion 82 is enabled to realize the sliding function.

In some embodiments, a sliding groove is defined on the supporting portion 81 and the sliding portion 82 is disposed in the sliding groove. A surface of a side of the sliding portion 82 that faces the flexible screen 4 is substantially flush with a surface of a side of the supporting portion 81 that faces the flexible screen 4, thereby enhancing the flatness of the second support 80.

In some embodiments, a symmetrical distribution of the rotating shaft assembly 1 and the second support 80 allows the rotating shaft assembly 1 and the second support 80 to share any components that are symmetrically distributed, thereby reducing the difficulty of design and the cost of mass production and realizing a modular production that has high production efficiency and facilitates a reliable control over the parts.

In some embodiments, due to the concise structure of the rotating shaft assembly 1, the structure of the second support 80 may be simplified correspondingly. Compared to the second support 80 that is provided with a complicated structure through a sophisticated process, such as a powder metallurgy in the related art, the second support 80 provided by some embodiments of the present disclosure may be obtained only through a stamping process, which reduces the cost.

As illustrated in FIG. 31, FIG. 31 is a partial cross-sectional view of FIG. 30 along a D-D direction. In some embodiments, a through hole 810 is defined on the supporting portion 81. The sliding portion 82 includes a first part 821, a second part 822, and a third part 823. The first part 821 and the second part 822 are disposed on opposite sides of the supporting portion 81. The first part 821 is configured to be connected to the flexible screen 4. A size of the second part 822 is greater than a size of the through hole 810. The third part 823 penetrates the through hole 810 to connect the first part 821 and the second part 822. The size of the second part 822 is designed to be greater than the size of the through hole 810, which avoids the sliding portion 82 and the supporting portion 81 separating from one another and thus improves the connection performance between the sliding portion 82 and the supporting portion 81.

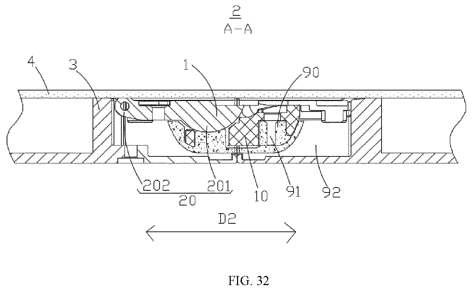

As further illustrated in FIG. 26 and FIG. 32, FIG. 32 is a partial cross-sectional view of FIG. 4 along an A-A direction according to still another embodiment of the present disclosure. In the present embodiment, the electronic device 2 further includes an installing or decorating member 90. An installing space 91 is defined in the installing or decorating member 90. At least a part of the rotating shaft assembly 1 is disposed in the installing space 91. The electronic device 2 has an unfolded state where an extending direction of each of the two first rotating members 20 being substantially parallel to an arrangement direction of the two first rotating members 20. When the electronic device 2 is in the unfolded state, an accommodating space 92 is defined by the two housings 3. The installing or decorating member 90 is disposed in the accommodating space 92.

The installing or decorating member 90 is configured to mount the rotating shaft assembly 1 on the installing or decorating member 90. In some embodiments, the base 10, the mounting member 68, and other components may be fixed to the installing or decorating member 90 to provide the fundamental of mounting. In addition, the installing or decorating member 90 may further enable at least a part of the rotating shaft assembly 1 to be mounted in the installing space 91, which provides a protection, a shield, and other functions for the rotating shaft assembly 1, thereby improving the safety and visual performance of the electronic device 2. A shape, a structure, a material, and etc., of the installing or decorating member 90 are not limited herein, as long as the installing or decorating member 90 is enabled to perform the mounting function. When the electronic device 2 is in the unfolded state, the accommodating space 92 is defined by the two housings 3. The installing or decorating member is disposed in the accommodating space 92. In this way, the installing or decorating member 90 may not be seen from an outside of the electronic device 2 when the electronic device 2 is in the unfolded state, which further improves the visual performance of the electronic device 2. The installing or decorating member 90 may only be seen from the outside of the electronic device 2 when the two housings 3 rotate away from one another

The above provides a detailed illustration of some embodiments of the present disclosure, the principles and implementations of the present disclosure are described and explained herein. The above description may be merely used to help understand the methods and core ideas of the present disclosure. In addition, for the person of ordinary skills in the art, based on the ideas of the present disclosure, there may be changes made in the specific implementations and scope of relevant applications. In summary, the contents of this specification shall not be understood as a limitation to the present disclosure.

## Claims

1. A rotating shaft assembly for an electronic device, the electronic device comprising a flexible screen and two housings, the rotating shaft assembly comprising:
a base; and
two first rotating members, rotating in opposite directions, wherein each of the two first rotating members comprises a first connecting end and a second connecting end disposed opposite to the first connecting end, the first connecting end is rotatably connected to the base, the second connecting end is configured to be rotatably connected to a corresponding one of the two housings, and each of the two first rotating members is configured to cooperate with a corresponding one of the two housings that is rotatable about a first rotation axis to support the flexible screen;
wherein along a direction substantially parallel to an arrangement direction of second rotation axes of the two first rotating members, the first rotation axes of the two housings are located between the second rotation axes of the two first rotating members; and
the rotating shaft assembly has a folded state where a distance between the first connecting ends of the two first rotating members is greater than a distance between the second connecting ends of the two first rotating members.

2. The rotating shaft assembly as claimed in claim 1, wherein when the rotating shaft assembly is in the folded state, along a direction substantially perpendicular to the arrangement direction of the second rotation axes of the two first rotating members, each of the second rotation axes is disposed closer to a corresponding one of the second connecting ends than a corresponding one of the first rotation axes.

3. The rotating shaft assembly as claimed in claim 1, further comprising:
two second rotating members, wherein an end of each of the two second rotating members is rotatably connected to the second connecting end of a corresponding one of the two first rotating members, and another end of each of the two second rotating members is configured to be connected to a corresponding one of the two housings.

4. The rotating shaft assembly as claimed in claim 3, wherein each of the two first rotating members comprises a mounting face that is configured to mount the flexible screen and at least a part of each of the two second rotating members is disposed at a side adjacent to a surface of a corresponding one of the two first rotating members opposite to the mounting face.

5. The rotating shaft assembly as claimed in claim 1, wherein a rotating space is defined on a side of the base;
each of the two first rotating members comprises a mounting portion and a connecting portion disposed on a side of the mounting portion, the connecting portion comprises the first connecting end, and the mounting portion comprises the second connecting end; and
a first rotating portion is disposed on an outer peripheral sidewall of the connecting portion, a second rotating portion is disposed on an inner sidewall of the rotating space, and the first rotating portion and the second rotating portion are configured to cooperate with one another to enable the two first rotating members to be rotatably connected to the base.

6. The rotating shaft assembly as claimed in claim 3, further comprising:
two third rotating members, a third axis of each of the two third rotating members being spaced apart from the first rotation axis of a corresponding one of the two housings;
wherein an end of each of the two third rotating members is rotatably connected to the base, another end of each of the two third rotating members is configured to be slidably connected to a corresponding one of the two housings or a corresponding one of the two second rotating members, and the two third rotating members are enabled to be driven by the two housings to rotate and to slide with respect to the two housings or the two second rotating members.

7. The rotating shaft assembly as claimed in claim 6, further comprising:
a synchronizing member, wherein an end of the synchronizing member is rotatably connected to one of the two third rotating members and another end of the synchronizing member is rotatably connected to the other one of the two third rotating members.

8. The rotating shaft assembly as claimed in claim 7, wherein the synchronizing member and the two third rotating members are disposed on a same side of the base, a first mating portion is disposed on at least one of the synchronizing member and the two third rotating members at a side away from the base, and the rotating shaft assembly further comprises:
at least one first rotating shaft, connected to the base, and penetrating the first mating portion and the at least one of the synchronizing member and the two third rotating members on which the first mating portion is disposed;
a sliding member, sleeved on the at least one first rotating shaft and disposed on a side of the first mating portion away from the base, wherein a second mating portion is disposed on a side of the sliding member that faces the first mating portion;
a blocking member, fixed to the at least one first rotating shaft and disposed on a side of the sliding member away from the base; and
a first elastic member, sleeved on the at least one first rotating shaft and disposed between the sliding member and the blocking member;
wherein each of the two third rotating members is configured to rotate synchronously along with the corresponding one of the two housings and further drive the first mating portion to rotate, the first mating portion and the second mating portion are configured to mate with each other to enable the sliding member to slide in a direction toward or away from the two third rotating members; and
when the sliding member slides in a direction away from the two third rotating members, the first elastic member is in a compressed state that enables the second mating portion to abut against the first mating portion and the two third rotating members to be turned into a stable state after the two third rotating members stop rotating.

9. The rotating shaft assembly as claimed in claim 8, wherein the first mating portion comprises a plurality of first bulges that are spaced apart from one another, the second mating portion comprises a plurality of second bulges that are spaced apart from one another, and a plurality of peaks are defined on the plurality of first bulges and the plurality of second bulges; and
when the sliding member slides in a direction away from the two third rotating members and the plurality of peaks on the plurality of first bulges are in contact with the plurality of peaks on the plurality of second bulges, the first elastic member is in the compressed state that enables the second mating portion to abut against the first mating portion.

10. The rotating shaft assembly as claimed in claim 8, wherein the first elastic member is disposed in a pre-compression state between the sliding member and the blocking member.

11. The rotating shaft assembly as claimed in claim 8, further comprises:
a second rotating shaft, connected to the base, and penetrating at least one of the synchronizing member and the two third rotating members that is free of being penetrated by the at least one first rotating shaft, wherein the sliding member is sleeved on the second rotating shaft and the blocking member is fixed to the second rotating shaft; and
a second elastic member, sleeved on the second rotating shaft and disposed between the blocking member and the sliding member;
wherein when the sliding member slides in a direction away from the two third rotating members, the second elastic member is in the compressed state that enables the second mating portion to abut against the first mating portion.

12. The rotating shaft assembly as claimed in claim 8, further comprising:
a friction member, disposed on a side of the blocking member away from the base;
wherein a flat structure is arranged on at least a part of an outer peripheral side of the at least one first rotating shaft;
the friction member and the at least one of the synchronizing member and the two third rotating members on which the first mating portion is disposed are sleeved on the flat structure, and the at least one first rotating shaft and the friction member are enabled to be driven by the first mating portion to rotate.

13. The rotating shaft assembly as claimed in claim 12, further comprising:
a mounting member, fixed to the at least one first rotating shaft and disposed on a side of the blocking member away from the base;
wherein the number of the friction member is two, one friction member is disposed between the blocking member and the mounting member, and the other friction member is disposed on a side of the mounting member away from the blocking member.

14. The rotating shaft assembly as claimed in claim 8, wherein a snap slot is defined on a periphery of an end of the at least one first rotating shaft at a side of the blocking member away from the base, the rotating shaft assembly further comprises a snap member, and a part of the snap member is disposed in the snap slot.

15. An electronic device, comprising:
a flexible screen;
a rotating shaft assembly; and
two housings, at least a part of one of the two housings and at least a part of the other one of the two housings being disposed on opposite sides of the rotating shaft assembly;
wherein the rotating shaft assembly further comprises:
a base; and
two first rotating members, rotating in opposite directions, wherein each of the two first rotating members comprises a first connecting end and a second connecting end disposed opposite to the first connecting end, the first connecting end is rotatably connected to the base, the second connecting end is configured to be rotatably connected to a corresponding one of the two housings, and each of the two first rotating members is configured to cooperate with a corresponding one of the two housings that is rotatable about a first rotation axis to support the flexible screen;
wherein along a direction substantially parallel to an arrangement direction of second rotation axes of the two first rotating members, the first rotation axes of the two housings are located between the second rotation axes of the two first rotating members;
wherein the rotating shaft assembly has a folded state where a distance between the first connecting ends of the two first rotating members is greater than a distance between the second connecting ends of the two first rotating members.

16. The electronic device as claimed in claim 15, further comprising:
a first support, disposed between the two first rotating members and configured to abut against the flexible screen;
wherein a raised portion is disposed on a side of each of the two first rotating members that faces the other one of the two first rotating members;
the electronic device has an unfolded state where an extending direction of each of the two first rotating members is substantially parallel to an arrangement direction of the two first rotating members and when the electronic device is in the unfolded state, the first support abuts against the raised portion; and
when the raised portion rotates, the first support is driven by the raised portion to move along a direction toward the base; and after the first support abuts against the base, the first support is separated from the raised portion.

17. The electronic device as claimed in claim 16, further comprising:
a bracket, disposed on a side of the first support away from the flexible screen and connected to the first support; and
a third elastic member, disposed between the bracket and the base;
wherein when the raised portion rotates, the third elastic member is in a deformation state that enables the third elastic member to drive the first support to move along a direction toward the base through a bouncing force.

18. The electronic device as claimed in claim 17, wherein a receiving space is defined on a side of the base away from the rotating space, the third elastic member and at least a part of the bracket are disposed in the receiving space, and the third elastic member is disposed on an inner sidewall of the receiving space.

19. The electronic device as claimed in claim 17, wherein the third elastic member is disposed in a pre-deformation state between the base and the bracket; when the first support abuts against the base, the third elastic member remains in the deformation state.

20. The electronic device as claimed in claim 15, further comprising:
a second support, comprising a supporting portion and a sliding portion slidably connected to the supporting portion,
wherein the supporting portion is connected to the two first rotating members and the sliding portion is configured to be connected to the flexible screen;
the electronic device has an unfolded state where an extending direction of each of the two first rotating members is substantially parallel to an arrangement direction of the two first rotating members; and when the electronic device is in the unfolded state, a sliding direction of the sliding portion is substantially parallel to the arrangement direction of the two first rotating members.

21. The electronic device as claimed in claim 20, wherein a through hole is defined on the supporting portion; and
the sliding portion comprises a first part, a second part, and a third part, the first part and the second part are disposed on opposite sides of the supporting portion, the first part is configured to be connected to the flexible screen, a size of the second part is greater than a size of the through hole, and the third part penetrates the through hole to connect the first part and the second part.

22. The electronic device as claimed in claim 15, further comprising:
an installing member, defining an installing space and at least a part of the rotating shaft assembly being disposed in the installing space;
wherein the electronic device has an unfolded state where an extending direction of each of the two first rotating members is substantially parallel to an arrangement direction of the two first rotating members; and
when the electronic device is in the unfolded state, an accommodating space is defined by the two housings and the installing member is disposed in the accommodating space.
